(19) Europäisches Patentamt / European Patent Office / Office européen des brevets

(11) **EP 4 474 884 B1**

(12) **EUROPEAN PATENT SPECIFICATION**

(45) Date of publication and mention
of the grant of the patent:
**18.02.2026 Bulletin 2026/08**

(51) International Patent Classification (IPC):
**G02B 26/10** *(2006.01)* **G02B 27/09** *(2006.01)*

(52) Cooperative Patent Classification (CPC):
**G02B 26/101; G02B 27/0966**

(21) Application number: **24166604.9**

(22) Date of filing: **27.03.2024**

(54) **APPARATUS FOR MANUFACTURING DISPLAY DEVICE AND DISPLAY DEVICE MANUFACTURED USING THE APPARATUS**

VORRICHTUNG ZUR HERSTELLUNG EINER ANZEIGEVORRICHTUNG UND MIT DER VORRICHTUNG HERGESTELLTE ANZEIGEVORRICHTUNG

APPAREIL DE FABRICATION DE DISPOSITIF D'AFFICHAGE ET DISPOSITIF D'AFFICHAGE FABRIQUÉ À L'AIDE DE L'APPAREIL

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **04.05.2023 KR 20230058469**

(43) Date of publication of application:
**11.12.2024 Bulletin 2024/50**

(73) Proprietor: **Samsung Display Co., Ltd.**
**Yongin-si, Gyeonggi-do 17113 (KR)**

(72) Inventors:
• **MISHCHIK, Konstantin**
**17113 Giheung-gu, Yongin-si (KR)**
• **Kim, Hyung Sik**
**17113 Giheung-gu, Yongin-si (KR)**
• **ROH, Cheol Lae**
**17113 Giheung-gu, Yongin-si (KR)**
• **RYU, Je Kil**
**17113 Giheung-gu, Yongin-si (KR)**
• **YOU, Jung Hwa**
**17113 Giheung-gu, Yongin-si (KR)**
• **JEONG, Seong Ho**
**17113 Giheung-gu, Yongin-si (KR)**

(74) Representative: **Dr. Weitzel & Partner**
**Patent- und Rechtsanwälte mbB**
**Friedenstrasse 10**
**89522 Heidenheim (DE)**

(56) References cited:
**JP-B2- 7 090 930     US-B2- 9 201 008**

**Description**

**BACKGROUND**

**1. Field**

Aspects of embodiments of the present invention relate to an apparatus for manufacturing a display device and a display device manufactured using the apparatus.

**2. Description of the Related Art**

As the information society develops, demand for display devices for displaying images in various forms is increasing. The display devices may be flat panel display devices, such as liquid crystal displays, field emission displays, and light emitting displays.

A display device includes a display area at where images are displayed and a non-display area disposed around the display area, for example, surrounding a periphery of the display area. Recently, a width of the non-display area has been gradually reduced to increase immersion in the display area and enhance the aesthetic appearance of the display device.

In a process of manufacturing the display device, the display device may be formed by cutting a mother substrate between a plurality of display cells formed on the mother substrates.

The non-display area may include a first non-display area in which lines and circuits for driving the display area are disposed and a second non-display area corresponding to a margin for a cutting process in the manufacturing process. Because there is a limit to reducing the number of lines and circuits in the first non-display area, a method of reducing the width of the second non-display area is being researched.

A laser processing apparatus may be used to cut the mother substrate. The laser processing apparatus is an apparatus for processing a material by using a laser beam, such as cutting, pattern forming, and welding. A laser beam used in laser processing has strong directivity and high density. In particular, a high-power laser beam that does not affect the surrounding material and enables precision processing can be used to process a display panel. The document JP 7 090930 B2 describes an apparatus for manufacturing a display device relevant to the present invention.

**SUMMARY**

The invention is defines by the independent claims. Embodiments of the present invention provide an apparatus for manufacturing a display device, the apparatus having improved optical properties, such as a numerical aperture (NA), beam size, and optical aberration of a laser beam.

However, aspects and features of the present invention are not limited to those set forth herein. The above and other aspects and features of the present invention will become more apparent to one of ordinary skill in the art to which the present invention pertains by referencing the detailed description of the present invention given below.

The present invention provides an apparatus for manufacturing a display device includes: a light source for generating a first beam; a beam converter including an axicon lens for converting the first beam into a second beam and a relay lens for converting the second beam into a third beam; a scanner including a first mirror for reflecting the third beam in a first direction and a second mirror for reflecting the third beam in a second direction different from the first direction; and a scan lens having an effective focal length and being for converting the third beam output from the scanner into a fourth beam. The scan lens includes a first lens having a first focal length, a second lens having a second focal length, a third lens having a third focal length, a fourth lens having a fourth focal length, a fifth lens having a fifth focal length, and a cover window, and an absolute value of the first focal length is smaller than an absolute value of each of the second through fifth focal lengths.

The first through fifth lenses and the cover window may be sequentially arranged.

The first beam may be a Gaussian beam, the second beam may be a raw Bessel beam, the third beam may be a ring-shaped beam, and the fourth beam may be a final Bessel beam.

The first through fifth focal lengths may be defined as f1, f2, f3, f4 and f5, respectively, the effective focal length may be defined as fG, and the first through fifth focal lengths and the effective focal length may satisfy Equation 1:

$$-1.4 < f1/fG < -1.0, \ +3.0 < f2/fG < +3.4, \ +3.1 < f3/fG < +3.3, \ +3.3 < f4/fG < +3.7, \ +3.5 < f5/fG < +3.9.$$

The first mirror may be configured to deflect the third beam in the first direction by a first angle, and the second mirror may be configured to deflect the third beam in the second direction by a second angle.

The first angle may be βx, the second angle may be βy, a distance between the first mirror and the second mirror may be M1, a distance between the second mirror and the scan lens may be M2, a distance by which the third beam, before being incident on the scan lens, is deflected in the first direction may be a first movement distance Δx, a distance by which the third beam, before being incident on the scan lens, is deflected in the second direction may be a second movement distance Δy, and the first movement distance Δx and the second movement distance Δy may satisfy Equation 2:

$$\Delta x = (M1+M2)*\beta x, \ \Delta y = M2*\beta y.$$

The third beam may be a ring-shaped beam having a diameter of 2WO, and a size CA of a clear aperture of the scan lens may satisfy Equation 3:

$$CA > \max(\Delta y, \Delta x) + 2W0.$$

Half of a length of a scanning field in the first direction formed on a focal plane by the fourth beam may be dx, half of a length of the scanning field in the second direction formed on a focal plane by the fourth beam may be dy, dx may be equal to a value obtained by multiplying the first angle by the effective focal length, and dy may be equal to a value obtained by multiplying the second angle by the effective focal length.

An effective length of the second beam may be longer than an effective length of the fourth beam.

A distance between the relay lens and the axicon lens may be equal to a distance between the relay lens and an entrance pupil of the scanner.

The distance between the relay lens and the axicon lens and the distance between the relay lens and the entrance pupil of the scanner may be equal to a sixth focal length, and the sixth focal length may be a focal length of the relay lens.

The first lens may be a double concave lens, the second lens and the fifth lens may be meniscus lenses, and the third lens and the fourth lens may be double convex lenses.

The second lens may be a concave incident surface and a convex exit surface, and the fifth lens may be a convex incident surface and a concave exit surface.

A distance between an entrance pupil of the scanner and the first lens may be greater than a distance between the first lens and the second lens.

The distance between the entrance pupil of the scanner and the first lens may be in a range of 15 mm to 50 mm.

The distance between the first lens and the second lens may be greater than a distance between the second lens and the third lens.

The distance between the second lens and the third lens may be equal to a distance between the third lens and the fourth lens and a distance between the fourth lens and the fifth lens.

A retroreflection point to which the third beam is retroreflected by the cover window may not be located on the first through fifth lenses.

The retroreflection point may be located between the first lens and the second lens.

A display device may be manufactured by using the apparatus described above. The display device may include: a glass substrate having a first surface, a second surface facing the first surface, a side surface connected to the first surface, and a first inclined surface extending between the side surface and the second surface; and a display area having a plurality of emission areas on the first surface of the glass substrate. The side surface and the first inclined surface may be formed by irradiating a laser beam to form first laser irradiation areas and then separating the glass substrate from a mother substrate along the first laser irradiation areas through an etching process, and the laser beam may be the fourth beam of the apparatus for manufacturing the display device described above.

An apparatus for manufacturing a display device, according to an embodiment of the present invention, may have improved optical properties, such as a numerical aperture (NA), beam size, and optical aberration of a laser beam.

However, the aspects and features of the present invention are not limited to those set forth herein. The above and other aspects and features of the present invention will become more apparent to one of ordinary skill in the art to which the present invention pertains by referencing the detailed description and the claims that follow.

## BRIEF DESCRIPTION OF THE DRAWINGS

These and/or other aspects and features of the present invention will become apparent and more readily appreciated from the following description of embodiments thereof, taken in conjunction with the accompanying drawings, in which:

FIG. 1 is a schematic diagram illustrating a laser processing apparatus according to an embodiment;
FIG. 2 is a schematic diagram illustrating a beam converter according to an embodiment;

FIG. 3 is an enlarged view of the area I of FIG. 2;

FIG. 4 is a schematic diagram illustrating a ring-shaped beam according to an embodiment;

FIG. 5A is a schematic diagram illustrating a scanner and a scan lens according to an embodiment;

FIG. 5B is a schematic diagram illustrating the path of a laser beam according to a tilt angle of a first mirror according to an embodiment;

FIG. 5C is a schematic diagram illustrating the path of a laser beam according to a tilt angle of a second mirror according to an embodiment;

FIG. 6 is a diagram illustrating the scanner and the scan lens according to an embodiment;

FIG. 7 is a diagram illustrating an operating state of the laser processing apparatus according to an embodiment;

FIG. 8 is an enlarged view of the area II of FIG. 7;

FIG. 9 is a diagram showing simulation results obtained by measuring optical aberrations of a third beam before being incident on the scan lens according to an embodiment;

FIG. 10 is a diagram showing simulation results obtained by measuring energy distributions of a fourth beam according to an embodiment;

FIG. 11 is a perspective view of a display device according to an embodiment;

FIG. 12 is a plan view illustrating a display panel and driving integrated circuits (ICs) according to an embodiment;

FIG. 13 is a cross-sectional view taken along the lines XA-XA' and XB-XB' of FIG. 11;

FIG. 14 is a cross-sectional view illustrating a bent state of the display device shown in FIG. 13;

FIG. 15 is a cross-sectional view illustrating a display area of a display panel according to an embodiment;

FIG. 16 is an enlarged view of the area A of FIG. 12;

FIG. 17 is an enlarged view of the area B of FIG. 12;

FIG. 18 is an enlarged view of the area C of FIG. 12;

FIG. 19 is a cross-sectional view taken along the line XC-XC' of FIG. 16;

FIG. 20 is a cross-sectional view taken along the line XD-XD' of FIG. 17;

FIG. 21 is a cross-sectional view taken along the line XE-XE' of FIG. 18;

FIG. 22 is an enlarged view of the area E of FIG. 19;

FIG. 23 is an enlarged view of the area F of FIG. 20;

FIG. 24 is an enlarged view of the area G of FIG. 21;

FIG. 25 is an enlarged view of the area D of FIG. 12;

FIG. 26 is a cross-sectional view taken along the line XF-XF' of FIG. 25;

FIG. 27 is an enlarged view of the area H of FIG. 26;

FIG. 28 is a detailed cross-sectional view taken along the lines XA-XA' and XB-XB' of FIG. 11 according to another embodiment;

FIG. 29 is a cross-sectional view illustrating a bent state of the display device shown in FIG. 28;

FIG. 30 is a flowchart describing a method of manufacturing a display device using a laser processing apparatus according to an embodiment;

FIG. 31 is an example view illustrating depths of laser irradiation areas formed by the laser processing apparatus according to an embodiment;

FIGS. 32 through 37 are perspective views illustrating steps of the method of manufacturing the display device using the laser processing apparatus according to an embodiment; and

FIGS. 38 through 47 are cross-sectional views illustrating steps of the method of manufacturing the display device using the laser processing apparatus according to an embodiment.

## DETAILED DESCRIPTION

The present invention will now be described more fully hereinafter with reference to the accompanying drawings, in which embodiments of the present invention are shown. The present invention may, however, be embodied in different forms and should not be construed as limited to the embodiments described herein. Rather, these embodiments are provided so that this invention will be thorough and complete and will fully convey the scope of the present invention to those skilled in the art.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present invention relates to "one or more embodiments of the present invention." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention and is not intended to be limiting of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Hereinafter, embodiments of the present invention will be described, in detail, with reference to the accompanying drawings.

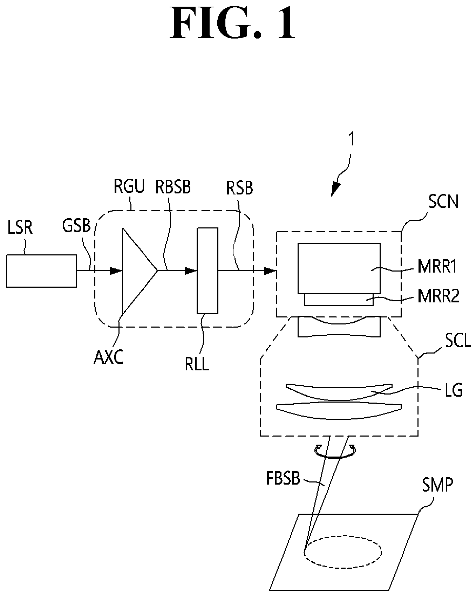

FIG. 1 is a schematic diagram illustrating a laser processing apparatus according to an embodiment.

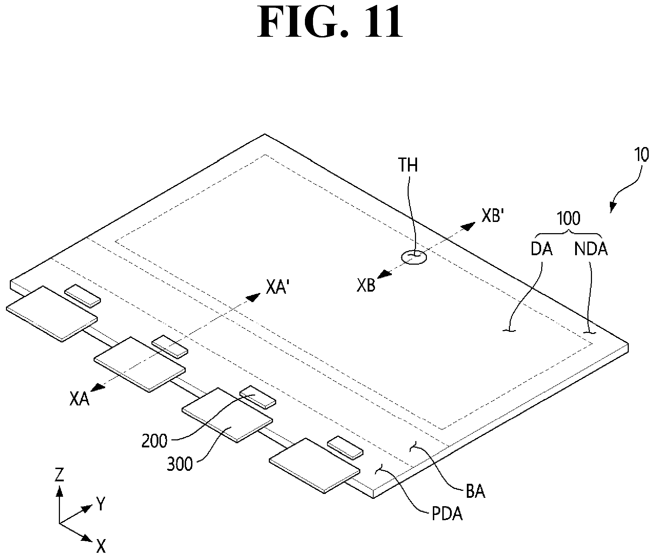

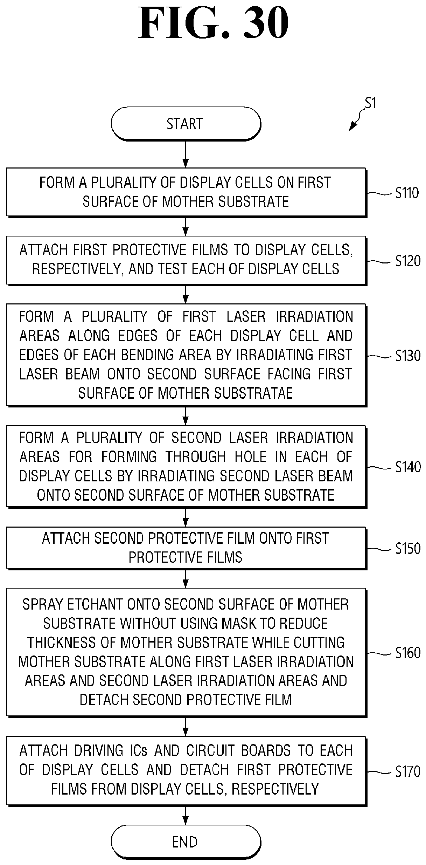

Referring to FIG. 1, the laser processing apparatus 1, according to an embodiment, is an apparatus for manufacturing a display device 10 (see, e.g., FIG. 11), which will be described later, and may be used for (e.g., may be used in or used to perform) a method S1 of manufacturing a display device (see, e.g., FIG. 30), which will also be described later. The laser processing apparatus 1, according to an embodiment, may be used to process a sample SMP by converting a Gaussian beam into a Bessel beam. For example, the laser processing apparatus 1 may be used to cut a mother substrate of a display device, to apply heat to the mother substrate or a structure on the mother substrate, and/or to perform patterning.

A display device manufactured by using the laser processing apparatus 1 may be applied to various electronic devices including small and medium-sized electronic equipment, such as tablet personal computers (PCs), smartphones, car navigation units, cameras, center information displays (CIDs) provided in vehicles, wristwatch-type electronic devices, personal digital assistants (PDAs), portable multimedia players (PMPs), and game consoles, and medium and large-sized electronic equipment, such as televisions, outdoor billboards, monitors, PCs, and notebook computers. Such applications are merely presented as examples, and the display device may also be employed in other electronic devices.

The laser processing apparatus 1 may include a light source LSR, a beam converter RGU, a scanner SCN, and a scan lens SCL. The light source LSR, the beam converter RGU, the scanner SCN, and the scan lens SCL may be sequentially arranged based on (e.g., along) a travelling direction of a laser beam.

The light source LSR may be one of various known laser generating devices. The light source LSR may emit a first beam GSB. The light source LSR may continuously or discontinuously emit the first beam GSB. The wavelength, amplitude, energy density, etc. of the first beam GSB may be adjusted by the light source LSR.

The wavelength of the first beam GSB may be in a range of about 340 nm to about 360 nm. However, embodiments of the present invention are not limited thereto. For example, the wavelength of the first beam GSB may exceed 360 nm. An emission time of the first beam GSB may be shorter than about 1 nanosecond. For example, the emission time of the first beam GSB may be tens of pico seconds or tens of femto seconds. However, embodiments of the present invention are not limited thereto, and the emission time of the first beam GSB may also be relatively long, that is, may be tens of seconds to several minutes.

The laser light source LSR may emit a single beam or may emit multiple beams.

The first beam GSB emitted from the laser light source LSR may be analyzed by using a separately provided beam profiler. For example, a cross-section of the first beam GSB emitted from the laser light source LSR may be measured, and whether or not the cross-section is circular or elliptical may be determined. When the cross-section of the first beam GSB is elliptical, directions of major and minor axes of the ellipse and a ratio between a length of the major axis and a length of the minor axis may be measured.

The first beam GSB may be incident on the beam converter RGU in the form of a Gaussian beam. The beam converter RGU may convert the first beam GSB in the form of a Gaussian beam into a ring-shaped Bessel beam. The beam converter RGU may include an axicon lens AXC and a relay lens RLL.

The axicon lens AXC may convert the first beam GSB into a second beam RBSB. For example, the axicon lens AXC may convert the first beam GSB in the form of a Gaussian beam into the second beam RBSB in the form of a raw Bessel beam.

The relay lens RLL may convert the second beam RBSB into a third beam RSB. For example, the relay lens RLL may convert the second beam RBSB in the form of a raw Bessel beam into the third beam RSB in the form of a ring-shaped Bessel beam.

The third beam RSB in the form of a ring-shaped Bessel beam may be incident on the scanner SCN. The scanner SCN may change the traveling direction of an incident laser beam. For example, the scanner SCN may change the traveling direction of the third beam RSB output from the beam converter RGU toward the sample SMP. The scanner SCN may be a galvanometer scanner or galvo scanner.

The scanner SCN may include two mirrors having different rotational axes. For example, the scanner SCN may include a first mirror MRR1 and a second mirror MRR2. Each of the first mirror MRR1 and the second mirror MRR2 may be a galvanometer mirror or galvo mirror.

The scanner SCN, which includes two mirrors having different rotational axes, may change the path of the third beam RSB having a 2D shape, such as a ring shape. Accordingly, a 2D scanning field may be implemented on (e.g., may be incident on) the sample SMP.

The 2D shape may refer to a unit shape of a plane defined by (e.g., extending in) a combination of a first direction and a second direction different from the first direction rather than a straight line defined only by the first direction. For example, the 2D shape may refer to the shape of a figure, such as a circle or a quadrilateral. The scanning field may refer to an area of the sample SMP that is scanned by a laser beam irradiated onto the sample SMP.

The third beam RSB, whose path has been changed by the scanner SCN as it passes through the scanner SCN, may be incident on the scan lens SCL. The scan lens SCL may include one lens or a plurality of lenses. For example, the scan lens SCL may include a lens group LG including a plurality of lenses. A laser beam output from the scanner SCN may be focused on the scanning field on the sample SMP by adjusting the focus of the laser beam.

The third beam RSB output from the scanner SCN may be converted into a fourth beam FBSB as it passes through the scan lens SCL. For example, the ring-shaped third beam RSB may be converted into the fourth beam FBSB in the form of a final Bessel beam. The fourth beam FBSB output from the scan lens SCL may reach (e.g., may be incident on) the sample SMP. For example, when the sample SMP is a mother substrate of a display device, the fourth beam FBSB may reach the mother substrate in the form of a final Bessel beam and may cut the mother substrate or may form a through hole in the mother substrate.

The laser processing apparatus 1 may further include a stage for providing a space in which (or on which) the sample SMP can be mounted.

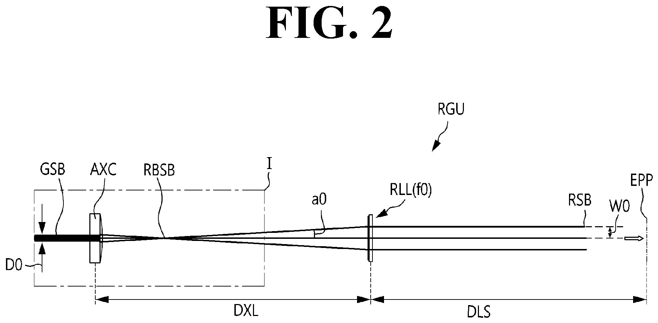

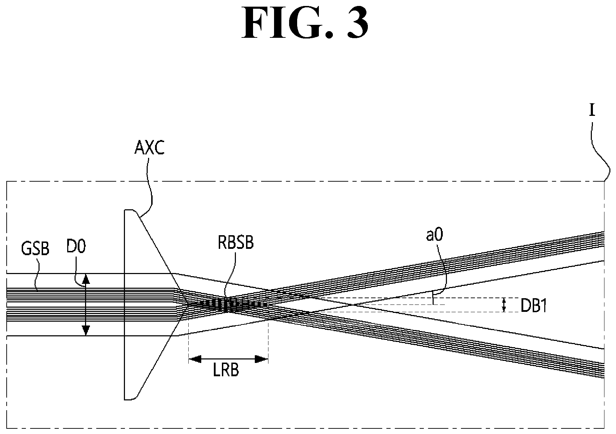

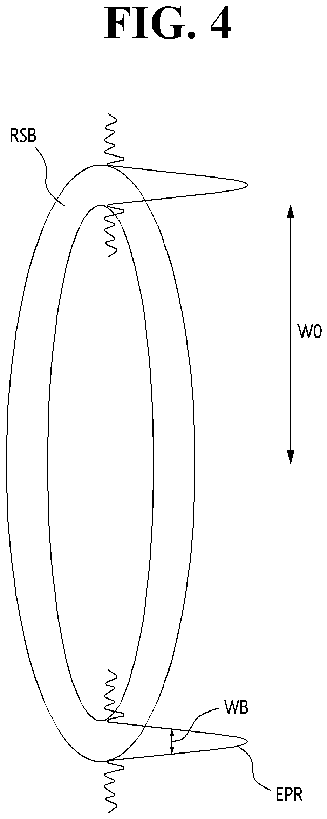

FIG. 2 is a schematic diagram illustrating a beam converter RGU according to an embodiment. FIG. 3 is an enlarged view of the area I of FIG. 2. FIG. 4 is a schematic diagram illustrating a ring-shaped beam according to an embodiment.

Referring to FIGS. 2 through 4 in addition to FIG. 1, the first beam GSB may be incident on the beam converter RGU in the form of a Gaussian beam. A diameter D0 of the first beam GSB may be variously changed according to wavelength, amplitude, energy density, and the like. In an embodiment, the diameter of the first beam GSB may be in a range of about 2 mm to about 15 mm based on a full width at $1/e^2$ level. The full width at $1/e^2$ level refers to the full width at a value of $1/e^2$ based on a maximum value of a beam profile.

The beam converter RGU may include an axicon lens AXC and a relay lens RLL. The axicon lens AXC and the relay lens RLL may be positions parallel to each other.

The axicon lens AXC may be a conical prism. For example, the axicon lens AXC may have a cone shape with a sharp lens center. The axicon lens AXC may convert the first beam GSB into the second beam RBSB. For example, the axicon lens AXC may convert the first beam GSB in the form of a Gaussian beam into the second beam RBSB in the form of a raw Bessel beam.

The axicon lens AXC, different from a general lens with a round lens surface, may not collect and focus all light passing therethrough to one point but may bend light in all radial directions at the same angle toward an optical axis. For example, the first beam GSB passing through the axicon lens AXC may travel to form a first refraction angle a0 with the optical axis of the axicon lens AXC (e.g., the central axis of the cone). Accordingly, light bent toward the optical axis may interfere with each other, and a central portion of the focused light may experience constructive interference. Therefore, the intensity of the central portion of the focused light may become higher than that of its surroundings, and the first beam GSB may be converted into the second beam RBSB in the form of a raw Bessel beam.

The axicon lens AXC is not limited to a conical lens. For example, the axicon lens AXC may be any suitable diffractive optical element performing the same function as the conical lens and configured to generate one or a plurality of parallel raw Bessel beams.

The second beam RBSB may be in the form of a raw Bessel beam. When the second beam RBSB is a Bessel beam, an effective length LRB of the Bessel beam of the second beam RBSB may be in a range of about 25 mm to about 250 mm. A diameter DB1 of the second beam RBSB may be in a range of about 10 $\mu$m to about 50 $\mu$m.

The second beam RBSB may travel in a ring shape toward the relay lens RLL, and a diameter of the ring may gradually increase.

The relay lens RLL may convert the second beam RBSB into the third beam RSB. For example, the relay lens RLL may convert the second beam RBSB in the form of a raw Bessel beam into the third beam RSB in the form of a ring-shaped Bessel beam. The second beam RBSB in the form of a raw Bessel beam may travel as a ring-shaped beam while gradually increasing in size. Then, as the second beam RBSB passes through the relay lens RLL, it may be converted into the ring-shaped third beam RSB having a constant radius WO.

As illustrated in FIG. 4, the third beam RSB may be formed as a Bessel beam that travels in a ring shape. The radius WO of the ring of the third beam RSB output from the relay lens RLL may be equal to the product of the first refraction angle a0 and a focal length f0 of the relay lens RLL. A width WB according to the full width at $1/e^2$ level of an energy profile EPR of the Bessel beam constituting the third beam RSB may be a value obtained by dividing the product of the wavelength of the first beam GSB and the focal length f0 of the relay lens RLL by the diameter D0 of the first beam GSB.

The relay lens RLL may be disposed between (e.g., in the middle between or equidistant between) an entrance pupil EPP of the scanner SCN and the axicon lens AXC. For example, a distance DXL between the relay lens RLL and the axicon lens AXC may be equal to a distance DLS between the relay lens RLL and the entrance pupil EPP of the scanner SCN. In addition, the distance DXL between the relay lens RLL and the axicon lens AXC and the distance DLS between the relay lens RLL and the entrance pupil EPP of the scanner SCN may be equal to the focal length f0 of the relay lens RLL.

The first beam GSB may pass through the axicon lens AXC to form the second beam RBSB, the second beam RBSB may pass through the relay lens RLL to form the third beam RSB, and the third beam RSB may be output from the beam converter RGU to enter the scanner SCN.

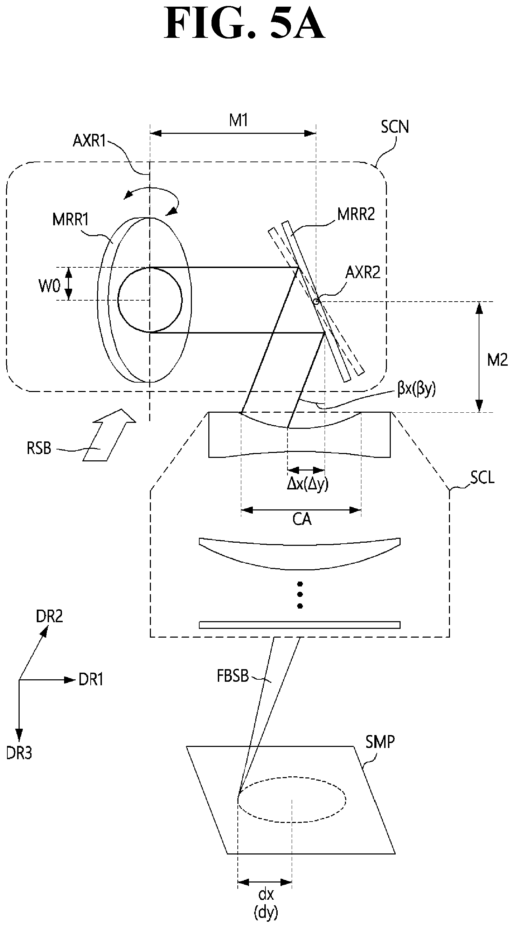

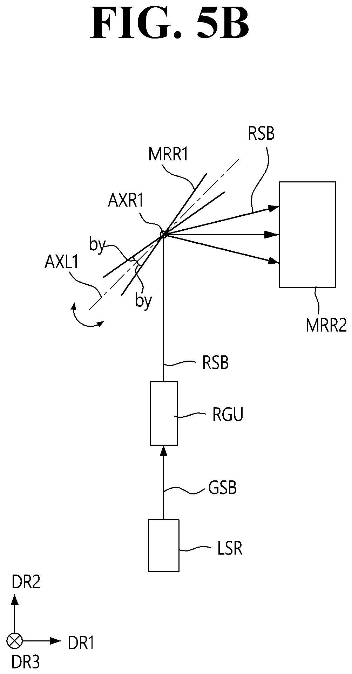

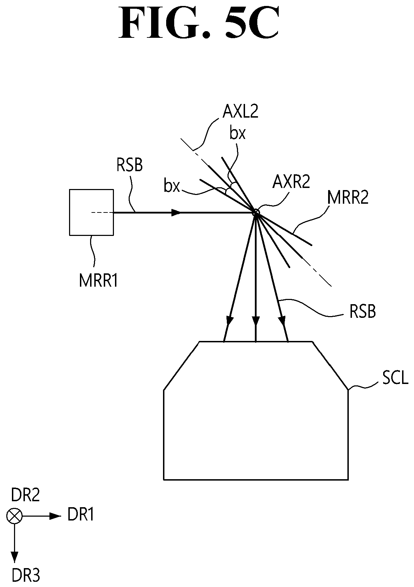

FIG. 5A is a schematic diagram illustrating a scanner SCN and a scan lens SCL according to an embodiment. FIG. 5B is a schematic diagram illustrating the path of a laser beam according to a tilt angle of a first mirror MRR1 according to an embodiment. FIG. 5C is a schematic diagram illustrating the path of a laser beam according to a tilt angle of a second mirror MRR2 according to an embodiment.

Referring to FIGS. 5A through 5C in addition to FIG. 1, the scanner SCN may change the traveling direction of an incident laser beam. For example, the scanner SCN may change the traveling direction of the third beam RSB output from the beam converter RGU toward the scanning lens SCL and the sample SMP. The scanner SCN, which includes two mirrors having different rotational axes, may change the path of the third beam RSB having a 2D shape, such as a ring shape. Accordingly, a 2D scanning field may be implemented on (e.g., may be incident on) the sample SMP.

The scanner SCN may include the first mirror MRR1 and the second mirror MRR2. The first mirror MRR1 and the second mirror MRR2 may be made of various materials that can reflect an incident laser beam. The first mirror MRR1 and the second mirror MRR2 may be angled to one another. The first mirror MRR1 may adjust a relative angle between the light source LSR and the beam converter RGU and the second mirror MRR2, and the second mirror MRR2 may adjust a relative angle between the first mirror MRR1 and the scan lens SCL.

First through third directions DR1 through DR3 are used for ease of description. In the drawings, the first direction DR1 and the second direction DR2 are horizontal directions crossing each other. For example, the first direction DR1 and the second direction DR2 may be orthogonal to each other, but embodiments of the present invention are not limited thereto. In addition, the third direction DR3 may cross the first direction DR1 and the second direction DR2. For example, the third direction DR3 may be a vertical direction orthogonal to the first direction DR1 and the second direction DR2, but embodiments of the present invention are not limited thereto. In the present invention, a direction indicated by an arrow of each of the first through third directions DR1 through DR3 may be referred to as one side, and the opposite direction may be referred to as the other side.

The first mirror MRR1 and the second mirror MRR2 may have different rotational axes. For example, the first mirror MRR1 may rotate about a first rotational axis AXR1 parallel to the third direction DR3, and the second mirror MRR2 may rotate about a second rotational axis AXR2 parallel to the second direction DR2.

The first mirror MRR1 may control the path of a laser beam in the first direction DR1 and the second direction DR2 by adjusting its tilt angle on a plane defined by the first direction DR1 and the second direction DR2.

The second mirror MRR2 may control the path of a laser beam in the first direction DR1 and the third direction DR3 by adjusting its tilt angle on a plane defined by the first direction DR1 and the third direction DR3.

A reflective surface of the first mirror MRR1 may be placed to face the light source LSR and the beam converter RGU. The first beam GSB emitted from the light source LSR may be converted into the ring-shaped third beam RSB through (e.g., in or by passing through) the beam converter RGU and may then be incident on the reflective surface of the first mirror MRR1. The third beam RSB traveling straight in one direction may be reflected in another direction not parallel to the one direction by the first mirror MRR1. For example, as illustrated in FIG. 5A, the third beam RSB travelling straight in the second direction DR2 may be reflected by the first mirror MRR1 to travel in a direction close to the first direction DR1 and to enter (e.g., to be incident on) the second mirror MRR2.

The first mirror MRR1 may rotate to have a plurality of intermittent tilts (e.g., rotation angles) on a plane defined by the first direction DR1 and the second direction DR2. For example, the first mirror MRR1 may rotate to have a first tilt and a second tilt different from the first tilt on a plane defined by the first direction DR1 and the second direction DR2. If an imaginary straight line having an average tilt of the first tilt and the second tilt is defined as a first auxiliary line AXL1, the first tilt may have an angle of by with respect to the first auxiliary line AXL1 in a counterclockwise direction, and the second tilt may have an angle of by in a clockwise direction. An angle between the first tilt and the second tilt is 2by.

An angle at which the third beam RSB is incident on the first mirror MRR1 may vary according to the tilt of the first mirror MRR1. For example, assuming that the third beam RSB has an incident angle of 45 degrees with respect to the first auxiliary line AXL1, the third beam RSB may have an incident angle of $(45° + by)$ with respect to the first mirror MRR1 when the first mirror MRR1 has the first tilt and may have an incident angle of $(45° - by)$ with respect to the first mirror MRR1 when the first mirror MRR1 has the second tilt.

The third beam RSB may have a reflection angle of $(45° + by)$ when the first mirror MRR1 has the first tilt and may have a reflection angle of $(45° - by)$ when the first mirror MRR1 has the second tilt according to the law of reflection.

Because the incident angle and reflection angle of the third beam RSB vary according to the tilt of the first mirror MRR1, even when the third beam RSB is incident on the same point on the first mirror MRR1, it may be incident on different points on the second mirror MRR2.

A reflective surface of the second mirror MRR2 may be placed (or arranged) to face the first mirror MRR1. The third beam RSB reflected from the first mirror MRR1 may be incident on the reflective surface of the second mirror MRR2. The third beam RSB traveling straight in one direction may be reflected toward the scan lens SCL by the second mirror MRR2.

The second mirror MRR2 may rotate to have a plurality of continuous tilts (e.g., rotation angles) on a plane defined by the first direction DR1 and the third direction DR3. The second mirror MRR2 may continuously rotate within the range of a third tilt and a fourth tilt different from the third tilt on the plane defined by the first direction DR1 and the third direction DR3. If an imaginary straight line having an average tilt of the third tilt and the fourth tilt is defined as a second auxiliary line AXL2, the third tilt may have an angle of bx with respect to the second auxiliary line AXL2 in the counterclockwise direction, and the fourth tilt may have an angle of bx in the clockwise direction. An angle between the third tilt and the fourth tilt is 2bx.

An angle at which the third beam RSB is incident on the second mirror MRR2 may vary according to the tilt of the second mirror MRR2. For example, assuming that the third beam RSB has an incident angle of 45 degrees with respect to the second auxiliary line AXL2, the third beam RSB may have an incident angle of $(45° + bx)$ with respect to the second mirror MRR2 when the second mirror MRR2 has the third tilt and may have an incident angle of $(45° - bx)$ with respect to the second mirror MRR2 when the second mirror MRR2 has the fourth tilt.

The third beam RSB may have a reflection angle of $(45° + bx)$ when the second mirror MRR2 has the third tilt and may have a reflection angle of $(45° - bx)$ when the second mirror MRR2 has the fourth tilt according to the law of reflection.

Because the incident angle and reflection angle of the third beam RSB vary according to the tilt of the second mirror MRR2, even when the third beam RSB is incident on the same point on the second mirror MRR2, it may be incident on different points on the scan lens SCL.

For example, when the third beam RSB is incident on the scanner SCN at incident angles of $(45° + by)$ and $(45° + bx)$ with respect to the first auxiliary line AXL1 and the second auxiliary line AXL2, respectively, it may be incident on the scan lens SCL after being deflected by $\beta x$ and $\beta y$ compared with when it is incident on the scanner SCN at an incident angle of 45 degrees with respect to the first auxiliary line AXL1 and the second auxiliary line AXL2. Because the third beam RSB is a 2D ring-shaped beam, $\beta x$ and $\beta y$ may be twice bx and by, respectively. Accordingly, the third beam RSB may be incident on the scan lens SCL after being deflected by a first movement distance $\Delta y$ and a second movement distance $\Delta x$.

When a separation distance M1 between the first mirror MRR1 and the second mirror MRR2 is M1 and a separation distance M2 between the second mirror MRR2 and the scan lens SCL is M2, the first movement distance $\Delta y$ and the second movement distance $\Delta x$ may respectively satisfy Equation 1 and Equation 2 below.

Equation 1:

$$\Delta y = (M1 + M2) * \beta y$$

Equation 2:

$$\Delta x = M2 * \beta x$$

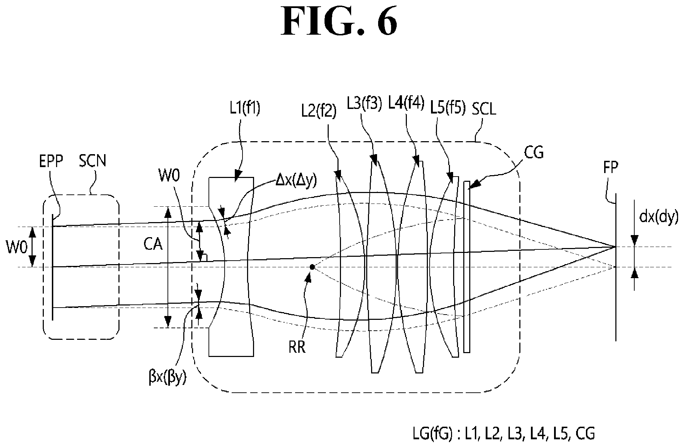

In some embodiments, the separation distance M1 between the first mirror MRR1 and the second mirror MRR2 and the separation distance M2 between the second mirror MRR2 and the scan lens SCL may vary according to an effective focal length fG (see, e.g., FIG. 6) of the scan lens SCL. For example, the separation distance M1 between the first mirror MRR1 and the second mirror MRR2 may be 2/3 times (2/3rds of) the effective focal length fG (see, e.g., FIG. 6), and the separation distance M2 between the second mirror MRR2 and the scan lens SCL may be 4/3 times the effective focal length fG.

A size CA of a clear aperture CA of the scan lens SCL may be set to satisfy Equation 3 below to prevent a clipping phenomenon in which some laser beams damage (e.g., reduce) the energy profile by failing to be incident on the scan lens SCL.

Equation 3:

$$CA > \max(\Delta y, \Delta x) + 2W0$$

As the third beam RSB passes through the scan lens SCL, it may be converted into the fourth beam FBSB to form a scanning field on the sample SMP. The shape of the scanning field is not limited to any one shape, such as a quadrilateral or a circle. However, for ease of description, an embodiment in which the scanning field is circular will be described as an example. A diameter of the scanning field may be 2dx or 2dy. Here, dx may be defined as the product of the effective focal length fG (see, e.g., FIG. 6) of the scan lens SCL and $\beta x$, and dy may be defined as the product of the effective focal length fG of the scan lens SCL and $\beta y$.

The scan lens SCL will now be described with reference to FIG. 6.

FIG. 6 is a diagram illustrating the scanner SCN and the scan lens SCL according to an embodiment.

Referring to FIG. 6 in addition to FIG. 1, the scan lens SCL may focus a laser beam output from the scanner SCN on a scanning field on the sample SMP by adjusting a focal length of the laser beam.

The third beam RSB output from the scanner SCN may be converted into the fourth beam FBSB as it passes through the scan lens SCL. For example, the ring-shaped third beam RSB may be converted into the fourth beam FBSB in the form of a final Bessel beam.

The scan lens SCL may include one lens or a plurality of lenses. Even when the scan lens SCL includes a plurality of lenses, the lenses may act as one lens (e.g., as one virtual lens). For example, the scan lens SCL may determine the effective focal length fG of the entire scan lens SCL by adjusting the focal length of each of the lenses. For example, the effective focal length fG may be in a range of about 20 mm to 60 mm.

The clear aperture CA of the scan lens SCL may be large enough to allow all laser beams deflected by the scanner SCN by the first movement distance $\Delta y$ and the second movement distance $\Delta x$ at angles of $\beta y$ and $\beta x$ to be incident on the scan lens SCL. The clear aperture CA of the scan lens SCL may satisfy Equation 3, as described above. For example, the clear aperture CA of the scan lens SCL may be in a range of about 10 mm to about 30 mm. The radius WO of a ring-shaped laser beam may be constant even when the laser beam is deflected by the scanner SCN.

The scan lens SCL may include a lens group LG including a plurality of lenses. The lens group LG may include a first lens L1 having a first focal length f1, a second lens L2 having a second focal length f2, a third lens L3 having a third focal length f3, a fourth lens L4 having a fourth focal length f4, a fifth lens L5 having a fifth focal length f5, and a cover window CG.

The first through fifth lenses L1 through L5 and the cover window CG may include fused silica.

The first lens L1 may have the first focal length f1. The first lens L1 may be a double concave lens; that is, the left and right surfaces of the first lens L1 may be concave. A thickness of the first lens L1 may be in a range of about 3 mm to about 5 mm.

The second lens L2 may be a meniscus lens having the second focal length f2. A left surface of the second lens L2 may be concave, and a right surface of the second lens L2 may be convex. A thickness of the second lens L2 may be in a range of about 5 mm to about 7 mm.

The third lens L3 may be a double convex lens having the third focal length f3, that is, the left and right surfaces of the third lens L3 may be convex. A thickness of the third lens L3 may be in a range of about 6 mm to about 8 mm.

The fourth lens L4 may be a double convex lens having the fourth focal length f4, that is, the left and right surfaces of the fourth lens L4 may be convex. A thickness of the fourth lens L4 may be in a range of about 6 mm to about 8 mm.

The fifth lens L5 may be a meniscus lens having the fifth focal length f5. A left surface of the fifth lens L2 may be convex, and a right surface of the fifth lens L2 may be concave. A thickness of the fifth lens L5 may be in a range of about 5 mm to about 7 mm.

A focal length of the cover window CG may be infinite. Left and right surfaces of the cover window CG may be flat. A thickness of the cover window CG may be in a range of about 1 mm to about 3 mm.

The left and right surfaces of each of the lenses L1 through L5 and the cover window CG refer to surfaces located on left and right sides of a center of each of the lenses L1 through L5 and the cover window CG, respectively. The left surface may be a surface on which a laser beam is incident, and the right surface may be a surface at where the laser beam exits.

In addition, each of the lenses L1 through L5 and the cover window CG may be considered as being concave when a curved surface is formed close to the center of each of the lenses L1 through L5 and the cover window CG and may be considered as being convex when the curved surface is formed far from the center.

In addition, the thickness of each of the lenses L1 through L5 and the cover window CG may refer to the thickness of a central portion thereof.

An absolute value of the focal length f1 of the first lens L1 may be smaller than an absolute value of each of the focal lengths f2 through f5 of the second through fifth lenses L2 through L5. Accordingly, a laser beam passing through the first lens L1 may be spread at a sufficient angle. The laser beam, which is spread as it passes through the first lens L1, may be collected again through (e.g., as it passes through) the second through fifth lenses L2 through L5.

A laser beam not deflected by the scanner SCN may be perpendicularly incident on a focal plane FP. On the other hand, a laser beam deflected by the first movement distance $\Delta y$ and the second movement distance $\Delta x$ by the scanner SCN may be incident on the focal plane FP at the angles of $\beta y$ and $\beta x$ when it does not pass through the scan lens SCL.

In the laser processing apparatus 1, according to the illustrated embodiment, the laser beam deflected by the first movement distance $\Delta y$ and the second movement distance $\Delta x$ by the scanner SCN may also be perpendicularly incident on the focal plane FP through the scan lens SCL.

The range of the laser beam that can be perpendicularly incident on the focal plane FP may form a scanning field. The diameter of the scanning field may be 2dx or 2dy as described above. In this embodiment, dx may be defined as the product of the effective focal length fG of the scan lens SCL and $\beta x$, and dy may be defined as the product of the effective focal length fG of the scan lens SCL and $\beta y$.

For a laser beam deflected by the first movement distance $\Delta y$ and the second movement distance $\Delta x$ by the scanner SCN to be perpendicularly incident on the focal plane FP, the focal lengths f1 through f5 of the first through fifth lenses L1 through L5 and the effective focal length fG of the scan lens SCL should satisfy Equation 4 below.

Equation 4:

$$-1.4<f1/fG<-1.0, +3.0<f2/fG<+3.4, +3.1<f3/fG<+3.3, +3.3<f4/fG<+3.7, +3.5<f5/fG<+3.9$$

A distance between the entrance pupil EPP of the scanner SCN and the first lens L1 may be greater than a distance between the first lens L1 and the second lens L2. The distance between the first lens L1 and the second lens L2 may be greater than a distance between the second lens L2 and the third lens L3. The distance between the second lens L2 and the third lens L3, a distance between the third lens L3 and the fourth lens L4, and a distance between the fourth lens L4 and the fifth lens L5 may be substantially equal to each other. A distance between the fifth lens L5 and the cover window CG may be smaller than the distance between the first lens L1 and the second lens L2 and greater than the distance between the second lens L2 and the third lens L3. The distances between the scanner SCN, the first through fifth lenses L1 through L5, and the cover window CG may be the shortest distances from among these distances.

For example, the distance between the entrance pupil EPP of the scanner SCN and the first lens L1 may be in a range of about 15 mm to about 50 mm. In one embodiment, the first lens L1 may be spaced apart from the entrance pupil EPP of the scanner SCN by about 35 mm. The distance between the first lens L1 and the second lens L2 may be in a range of about 10 mm to about 30 mm. The distance between the second lens L2 and the third lens L3, the distance between the third lens L3 and the fourth lens L4, and the distance between the fourth lens L4 and the fifth lens L5 may be equal to or less than 1 mm. The distance between the fifth lens L5 and the cover window CG may be in a range of about 1 mm to 5 mm.

Some of the laser beams passing through the first through fifth lenses L1 through L5 may not pass through the cover window CG but may be retroreflected to a retroreflection point RR located in a reverse direction as the laser traveling direction. The retroreflection point RR may not be located on the first through fifth lenses L1 through L5. The retroreflection point RR may be located in the air (e.g., may be located in space between lenses). For example, the retroreflection point RR may be located (e.g., may be located in space) between the first lens L1 and the second lens L2.

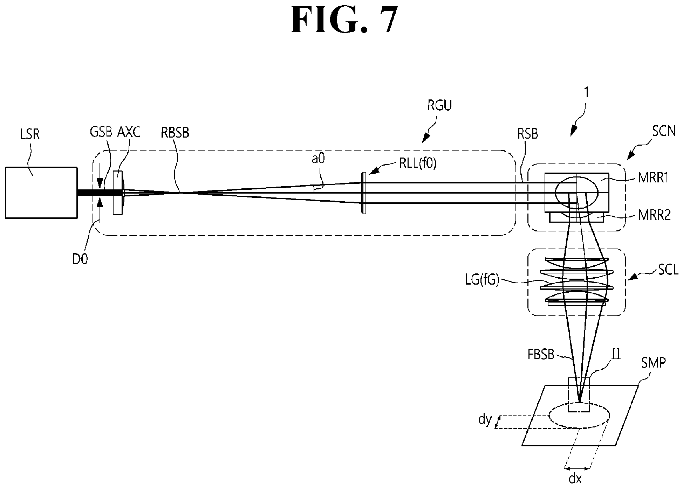

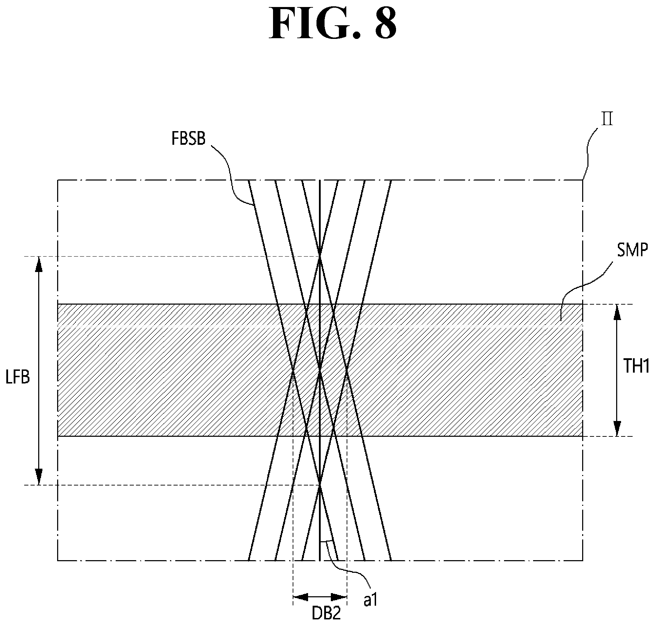

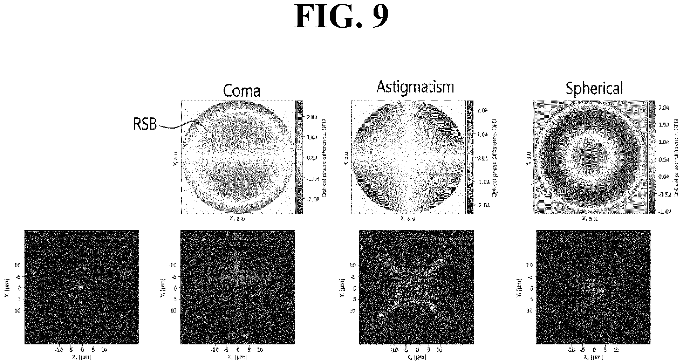

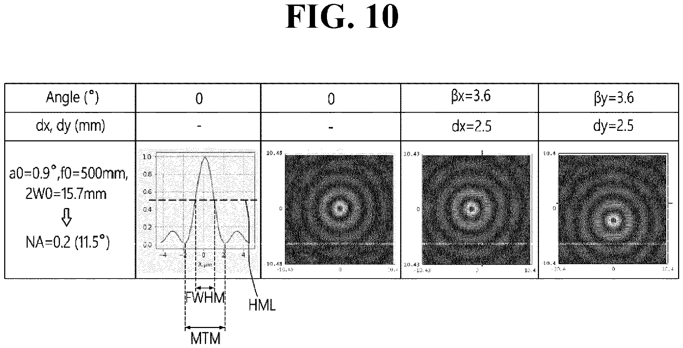

FIG. 7 is a diagram illustrating an operating state of the laser processing apparatus 1 according to an embodiment. FIG. 8 is an enlarged view of the area II of FIG. 7. FIG. 9 is a diagram showing simulation results obtained by measuring optical aberrations of the third beam RSB before being incident on the scan lens SCL according to an embodiment. FIG. 10 is a diagram showing simulation results obtained by measuring energy distributions of the fourth beam FBSB according to an embodiment.

Referring to FIGS. 7 through 10 in addition to FIG. 6, the first beam GSB emitted from the light source LSR may be incident on the beam converter RGU. As the first beam GSB in the form of a Gaussian beam passes through the axicon lens AXC of the beam converter RGU, it may be converted into the second beam RBSB in the form of a raw Bessel beam. As the second beam RBSB passes through the relay lens RLL of the beam converter RGU, it may be converted into the ring-shaped third beam RSB having a radius of WO. The third beam RSB may be incident on the scanner SCN. The third beam RSB may pass through the first mirror MRR1 and the second mirror MRR2 of the scanner SCN and enter the scan lens SCL. The third beam RSB may pass through the lens group LG of the scan lens SCL having the effective focal length fG and may reach the sample SMP in the form of the fourth beam FBSB, which is in the form of a final Bessel beam. The fourth beam FBSB may be made to (e.g., may be configured or shaped to) form a scanning field on the sample SMP by the driving of the scanner SCN. A length of the scanning field in the first direction DR1 may be dx, and a length of the scanning field in the second direction DR2 may be dy.

When the laser processing apparatus 1, according to an embodiment, is used to cut the sample SMP as in a process of manufacturing a display device, which will be described in more detail later, an effective length LFB of the fourth beam FBSB should be greater than a thickness TH1 of the sample SMP. In addition, a high numerical aperture (NA) value and a small beam size are beneficial (e.g., are necessary) for sufficient energy concentration and precise processing. For example, the required NA value may be about 0.2 or more, and the required beam size may be equal to or less than 2 $\mu$m. In addition, the fourth beam FBSB should be perpendicularly incident on a focal plane for uniform processing and energy transfer. In addition, a wide scanning field should be achieved for high-speed processing.

In FIG. 9, simulation results obtained by measuring optical aberrations of the third beam RSB before the third beam RSB, deflected by the first movement distance $\Delta y$, is incident on the scan lens SCL are shown. That is, coma aberration (e.g., comet aberration), astigmatism, and spherical aberration of the third beam RSB before the third beam RSB deflected by the first movement distance $\Delta y$ passes through the scan lens SCL are shown.

When the scan lens SCL is not used or is not optimized, the third beam RSB deflected by the first movement distance $\Delta y$ or the first movement distance $\Delta x$ may not be perpendicularly incident on the sample SMP. Accordingly, optical aberration characteristics may deteriorate, thereby degrading characteristics, such as the effective length LFB, intensity, and beam size of a final Bessel beam and the size of a scanning field.

For example, referring to the upper figure in FIG. 9 showing an optical phase difference (OPD) distribution in coma aberration, it can be seen that OPD values are significantly different in upper and lower parts in areas where the circumference of the third beam RSB is located. Referring to the lower figure in FIG. 9 showing the waveform of the third beam RSB in coma aberration, it can be seen that the third beam RSB spreads in a cross shape (+) without being concentrated on one point.

Referring to the upper figure in FIG. 9 showing the OPD distribution in astigmatism, it can be seen that OPD values are significantly different in first and third quadrants and second and fourth quadrants in the areas at where the circumference of the third beam RSB is located. Referring to the lower figure in FIG. 9 showing the waveform of the third beam RSB in astigmatism, it can be seen that the third beam RSB spreads in quadrilateral and X shapes without being concentrated on one point.

Referring to the upper figure in FIG. 9 showing the OPD distribution in spherical aberration, it can be seen that OPD values are significantly different in a central part and an outer part but are similar in the areas at where the circumference of the third beam RSB is located. That is, it can be seen that the difference in OPD value is at an acceptable level in terms of spherical aberration. Referring to the lower figure in FIG. 9 showing the waveform of the third beam RSB in spherical aberration, it can be seen that the third beam RSB is relatively focused on one point.

Through these simulation results, the scan lens SCL may be designed from the perspective of optimizing coma aberration and astigmatism. As described above with reference to FIG. 6, by optimizing the distances between the scanner SCN, the lenses L1 through L5 of the lens group LG, the cover window CG and the focal plane FP, and optimizing the effective focal length fG of the lens group LG and the focal lengths f1 through f5 of the lenses L1 through L5, optical aberrations may be optimized and characteristics, such as the effective length LFB, intensity, and beam size of a final Bessel beam, and the size of a scanning field may be improved.

Referring to FIG. 10, simulation results obtained by measuring energy distributions of the fourth beam FBSB obtained after the third beam RSB passes through the scan lens SCL with optimized settings are shown.

In the simulation, the first refraction angle a0 of the second beam RBSB passing through the axicon lens AXC is 0.9 degrees, the focal length f0 of the relay lens RLL is 500 mm, and the radius WO of the third beam RSB incident on the scanner SCN is 7.85 mm. In addition, a maximum aperture of the scanner SCN may be 20 mm, and a diameter of the entrance pupil EPP may be 18 mm.

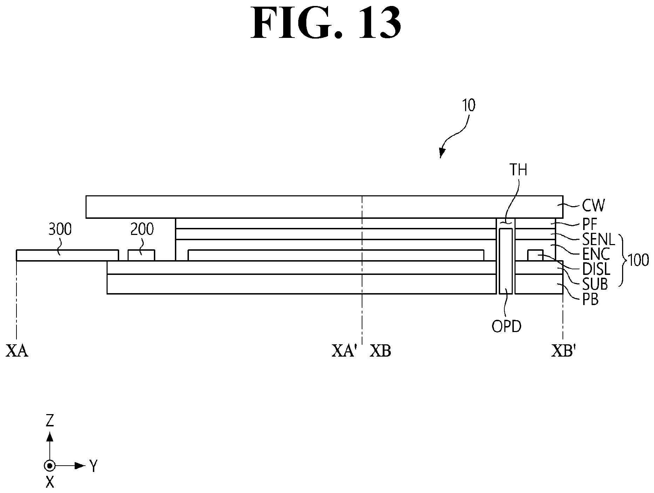

The laser processing apparatus 1, according to the illustrated embodiment, may secure the effective length LFB of the fourth beam FBSB, which is greater than the thickness TH1 of the sample SMP, by optimizing the setting of the scan lens SCL. For example, as illustrated in FIG. 8, when the sample SMP is a substrate SUB (see, e.g., FIG. 13) of a display device 10, which will be described in more detail later, the thickness TH1 of the sample SMP may be about 0.5 mm. The effective length LFB of the fourth beam FBSB may be in a range of about 0.4 mm to about 2 mm. A diameter DB2 of the fourth beam FBSB may be in a range of about 2 mm to about 10 mm.

In addition, the laser processing apparatus 1, according to the illustrated embodiment, may achieve a high NA value and a small beam size for sufficient energy concentration and precise processing. For example, referring to the graph illustrating the energy profile of the fourth beam FBSB shown in FIG. 10, when the deflection angles βx and βy of the third beam RSB are 0 degrees, a full width at half maximum (FWHM) measured based on a half maximum line (HML) is 1.85 μm, and a minimum to minimum (MTM) width is 3.9 μm. A second refraction angle a1, which is a refraction angle of the fourth beam FBSB, is 11.5 degrees, and an NA value, which is a sine function value of the second refraction angle a1, is about 0.2.

As described above with reference to FIGS. 2 and 3, the effective length LRB of the second beam RBSB is several mm, but the first refraction angle a0 is only 0.9 degrees. Therefore, the second beam RBSB has a significantly small NA value and a diameter DB1 in a range of about 10 μm to about 50 μm. Hence, the second beam RBSB is not suitable for direct use in a laser processing process. On the other hand, the fourth beam FBSB generated by the laser processing apparatus 1, according to the illustrated embodiment, may have a sufficient NA value, effective length, and diameter that make the fourth beam FBSB usable in the laser processing process.

In addition, the laser processing apparatus 1, according to the illustrated embodiment, may make the fourth beam FBSB be perpendicularly incident on a focal plane for uniform processing and energy transfer. For example, referring to the figures showing waveform distributions of the fourth beam FBSB in FIG. 10, it can be seen that when the deflection angles βx and βy of the third beam RSB are 0 degrees, energy is concentrated on the origin. In addition, even when the deflection angles βx and βy of the third beam RSB are 3.6 degrees, it can be seen that energy is concentrated on a point deflected from the origin by a certain distance. Therefore, it can be seen that even if the fourth beam FBSB is deflected by a specific angle or in a specific direction, the laser processing apparatus 1, according to the illustrated embodiment, can make the deflected laser beam be perpendicularly incident on the focal plane by optimizing the optical aberration of the deflected laser beam.

In addition, the laser processing apparatus 1, according to the illustrated embodiment, can achieve a wide scanning field for a fast high-speed process. A first deflection distance dx and a second deflection distance dy, which are deflection distances at which the fourth beam FBSB can be incident on the focal plane without degradation of optical characteristics, may be about 2.5 mm. Therefore, the laser processing apparatus 1 can achieve a scanning field area as wide as about 5 mm in diameter.

A display device manufactured by using the laser processing apparatus 1 according to an embodiment will now be described.

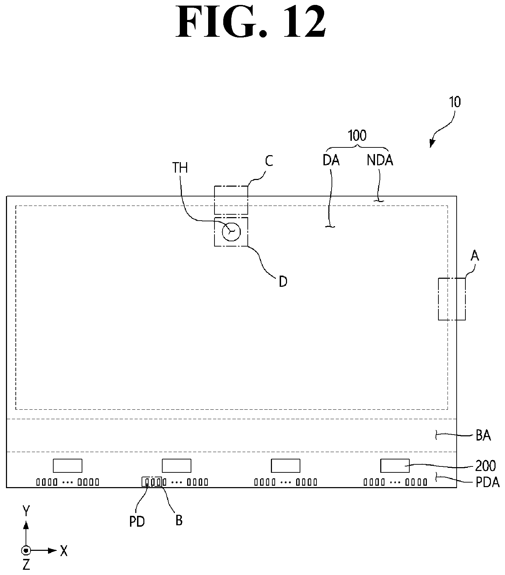

FIG. 11 is a perspective view of a display device 10 according to an embodiment. FIG. 12 is a plan view illustrating a display panel 100 and driving integrated circuits (ICs) 200 of the display device 10 according to an embodiment.

Referring to FIGS. 11 and 12, the display device 10, according to an embodiment, is a device for displaying moving images and/or still images. The display device 10 may be used as a display screen in portable electronic devices, such as mobile phones, smartphones, tablet PCs, smart watches, watch phones, mobile communication terminals, electronic notebooks, electronic books, PMPs, navigation devices, and ultra-mobile PCs (UMPCs), as well as in various products, such as televisions, notebook computers, monitors, billboards, and Internet of Things (IoT) devices.

The display device 10, according to an embodiment, may be a light emitting display device, such as an organic light emitting display device using an organic light emitting diode, a quantum dot light emitting display device including a quantum dot light emitting layer, an inorganic light emitting display device including an inorganic semiconductor, or a micro- or nano-light emitting display device using a micro- or nano-light emitting diode. An embodiment in which the display device 10 is an organic light emitting display device will be primarily described below, but the present invention is not limited thereto.

The display device 10, according to an embodiment, may include the display panel 100, the driving ICs 200, and circuit boards 300.

The display panel 100 may be shaped like a rectangular plane having long sides in a first direction (e.g., an X-axis direction) and short sides in a second direction (e.g., a Y-axis direction) crossing the first direction (X-axis direction). Each corner at where a long side extending in the first direction (X-axis direction) meets a short side extending in the second direction (Y-axis direction) may be right-angled or may be rounded with a curvature (e.g., a predetermined curvature). The planar shape of the display panel 100 is not limited to a quadrilateral shape but may also be another polygonal shape, a circular shape, or an oval shape.

In the drawings, the first direction (X-axis direction) and the second direction (Y-axis direction) are horizontal directions crossing each other. For example, the first direction (X-axis direction) and the second direction (Y-axis direction) may be orthogonal to each other. In addition, a third direction (Z-axis direction) may cross the first direction (X-axis direction) and the second direction (Y-axis direction), for example, may be a vertical direction orthogonal to the first direction (X-axis direction) and the second direction (Y-axis direction). In the present invention, a direction indicated by an arrow of each of the first through third directions (X-, Y- and Z-axis directions) may be referred to as one side, and the opposite direction may be referred to as the other side. The first through third directions (X-, Y- and Z-axis directions) below are irrelevant to (e.g., are unrelated to) the first through third directions DR1 through DR3 used above to describe FIGS. 5A through 5C.

The display panel 100 may be formed flat, but embodiments of the present invention are not limited thereto. For example, the display panel 100 may include curved portions formed at left and right ends and having a constant or varying curvature. In addition, the display panel 100 may be formed to be flexible so that it can be curved, bent, folded, or rolled.

The display panel 100 may include a display area DA for displaying an image and a non-display area NDA disposed around the display area DA.

The display area DA may occupy most of the area of the display panel 100. The display area DA may be disposed in a center of the display panel 100. Pixels respectively including a plurality of emission areas may be disposed in the display area DA to display an image.

The non-display area NDA may neighbor (e.g., may be directly adjacent to) the display area DA. The non-display area NDA may be an area outside the display area DA. The non-display area NDA may surround a periphery of the display area DA. The non-display area NDA may be an edge area of the display panel 100.

The non-display area NDA may have a bending area BA and a pad area PDA.

The bending area BA may be disposed between the display area DA and the pad area PDA in the second direction (Y-axis direction). The bending area BA may extend in the first direction (X-axis direction). The bending area BA is an area bent toward the bottom of the display panel 100. When the bending area BA is bent toward the bottom of the display panel 100, the driving ICs 200 and the circuit boards 300 may be disposed under the display panel 100.

The pad area PDA may be a lower edge area of the display panel 100. The pad area PDA may be an area at where display pads PD connected to the circuit boards 300 and first and second driving pads DPD1 and DPD2 connected to the driving ICs 200 are disposed.

The display pads DP to be connected to the circuit boards 300 may be disposed in the pad area PDA. The display pads DP may be disposed on an edge of the display panel 100. For example, the display pads DP may be disposed on a lower edge of the display panel 100.

The driving ICs 200 may generate data voltages, power voltages, scan timing signals, etc. The driving ICs 200 may output the data voltages, the power voltages, the scan timing signals, etc.

The driving ICs 200 may be disposed in the pad area PDA. The driving ICs 200 may be disposed in the non-display area NDA between the display pads PD and the display area DA. Each of the driving ICs 200 may be attached to the non-display area NDA of the display panel 100 by using a chip on glass (COG) method. In other embodiments, each of the driving ICs 200 may be attached to a circuit board 300 by using a chip on plastic (COP) method.

The circuit boards 300 may be disposed on the display pads DP disposed on an edge of the display panel 100. The circuit boards 300 may be attached to the display pads PD by using a conductive adhesive member, such as an anisotropic conductive film or an anisotropic conductive adhesive. Therefore, the circuit boards 300 may be electrically connected to signal lines in the display panel 100. Each of the circuit boards 300 may be a flexible printed circuit board or a flexible film, such as a chip on film.

A through hole TH may be formed at one side of the display area DA. The through hole TH may be a hole that can transmit light and may be an area at where an optical device is disposed.

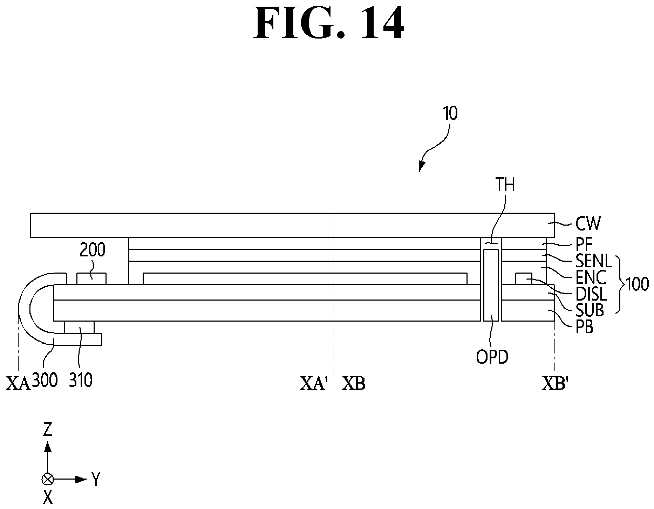

FIG. 13 is a cross-sectional view taken along the lines XA-XA' and XB-XB' of FIG. 11. FIG. 14 is a cross-sectional view illustrating a bent state of the display device 10 shown in FIG. 13.

Referring to FIGS. 13 and 14, the display device 10, according to an embodiment, may include the display panel 100, a polarizing film PF, a cover window CW, and an under-panel cover PB. The display panel 100 may include a substrate SUB, a display layer DISL, an encapsulation layer ENC, and a sensor electrode layer SENL.

The substrate SUB may be rigid. For example, the substrate SUB may be made of glass, also called as a glass substrate SUB. The substrate SUB (the glass substrate SUB) may be made of ultra-thin glass having a thickness of about 200 $\mu$m or less.

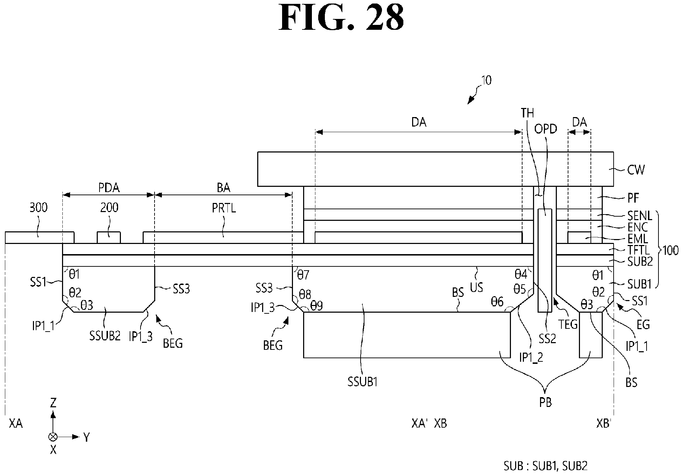

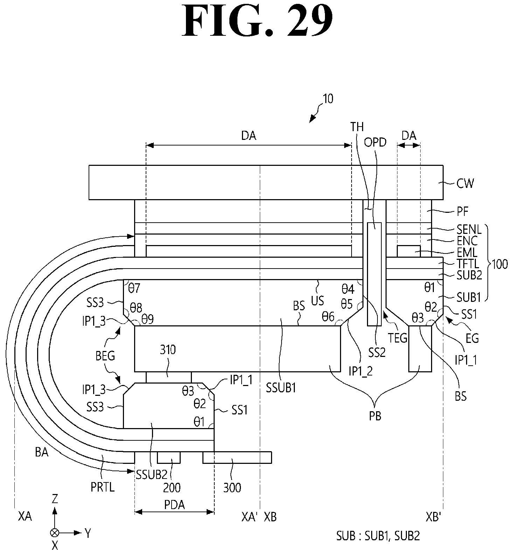

In an embodiment, the substrate SUB may include a first substrate SUB1 that is rigid and a second substrate SUB2 made of polymer resin that is ductile (e.g., flexible). The first substrate SUB1 and the second substrate SUB2 will be described below in more detail with reference to FIGS. 28 and 29.

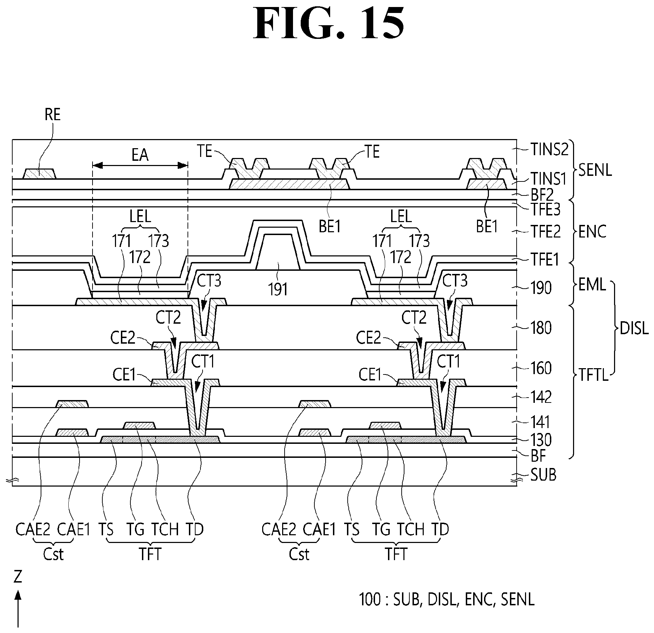

The display layer DISL may be disposed on a first surface of the substrate SUB. The display layer DISL may be a layer for displaying an image. The display layer DISL may include a thin-film transistor layer TFTL (see, e.g., FIG. 15) in which thin-film transistors are formed and a light emitting element layer EML (see, e.g., FIG. 15) in which light emitting elements emitting light are disposed in emission areas.

In the display area DA of the display layer DISL, scan lines, data lines, power lines, etc. may be disposed so that the emission areas can emit light. In the non-display area NDA of the display layer DISL, a scan driving circuit unit for outputting scan signals to the scan lines, fan-out lines connecting the data lines and the driving ICs 200, etc. may be disposed.

The encapsulation layer ENC may be a layer for encapsulating the light emitting element layer EML of the display layer DISL to prevent penetration of oxygen or moisture into the light emitting element layer EML of the display layer DISL. The encapsulation layer ENC may be disposed on the display layer DISL. The encapsulation layer ENC may be disposed on upper and side surfaces of the display layer DISL. The encapsulation layer ENC may cover the display layer DISL.

The sensor electrode layer SENL may be disposed on the display layer DISL. The sensor electrode layer SENL may include sensor electrodes. The sensor electrode layer SENL may sense a user's touch by using the sensor electrodes.

The polarizing film PF may be disposed on the sensor electrode layer SENL. The polarizing film PF may be disposed on the display panel 100 to reduce reflection of external light. The polarizing film PF may include a first base member, a linear polarizer, a phase retardation film, such as a quarter-wave ($\lambda$/4) plate, and a second base member. The first base member, the phase retardation film, the linear polarizer, and the second base member of the polarizing film PF may be sequentially stacked on the display panel 100.

The cover window CW may be disposed on the polarizing film PF. The cover window CW may be attached onto the polarizing film PF by a transparent adhesive member, such as an optically clear adhesive (OCA) film.

The under-panel cover PB may be disposed on a second surface of the substrate SUB of the display panel 100. The second surface of the substrate SUB may be a surface opposite the first surface. The under-panel cover PB may be attached to the second surface of the substrate SUB of the display panel 100 through an adhesive member. The adhesive member may be a pressure sensitive adhesive.

The under-panel cover PB may include at least one of a light blocking member for absorbing light incident from the outside, a buffer member for absorbing external shock, and a heat dissipation member for efficiently dissipating heat from the display panel 100.

The driving ICs 200 and the circuit boards 300 may be bent toward the bottom of the display panel 100. The circuit boards 300 may be attached to a lower surface of the under-panel cover PB by an adhesive member 310. The adhesive member 310 may be a pressure sensitive adhesive.

The through hole TH may be disposed in the display device 10 according to the embodiment. The through hole TH may be a hole that can transmit light and may be a physical hole penetrating not only the display panel 100 but also the under-panel cover PB and the polarizing film PF. For example, the through hole TH may penetrate (e.g., may extend through) the substrate SUB, the display layer DISL, the encapsulation layer ENC, and the sensor electrode layer SENL of the display panel 100. However, embodiments of the present invention are not limited thereto, and the through hole TH may also penetrate the under-panel cover PB but may not penetrate the display panel 100 and the polarizing film PF. The cover window CW may cover (e.g., may extend over) the through hole TH.

An electronic device including the display device 10, according to an embodiment, may further include an optical device OPD disposed in the through hole TH. The optical device OPD may be spaced apart from the display panel 100, the under-panel cover PB, and the polarizing film PF. The optical device OPD may be an optical sensor configured to sense light incident through the through hole TH, such as a proximity sensor, an illuminance sensor, or a camera sensor.

FIG. 15 is a cross-sectional view illustrating the display area DA of the display panel 100 according to an embodiment.

The display panel 100, according to an embodiment, may be an organic light emitting display panel having light emitting elements LEL, each including an organic light emitting layer 172. The display layer DISL may include the thin-film transistor layer TFTL including a plurality of thin-film transistors and the light emitting element layer EML including a plurality of light emitting elements.

The substrate SUB may be rigid. For example, the substrate SUB may be made of glass. The substrate SUB may be made of ultra-thin glass having a thickness of about 200 $\mu$m or less.

A buffer layer BF may be disposed on the substrate SUB. The buffer layer BF may be made of an inorganic material, such as a silicon nitride layer, a silicon oxynitride layer, a silicon oxide layer, a titanium oxide layer, or an aluminum oxide layer. In other embodiments, the buffer layer BF may be a multilayer in which a plurality of layers selected from a silicon nitride layer, a silicon oxynitride layer, a silicon oxide layer, a titanium oxide layer, and an aluminum oxide layer are alternately stacked.

An active layer including a channel region TCH, a source region TS, and a drain region TD of each thin-film transistor TFT may be disposed on the buffer layer BF. The active layer may be made of polycrystalline silicon, monocrystalline silicon, low-temperature polycrystalline silicon, amorphous silicon, or an oxide semiconductor material. When the active layer includes polycrystalline silicon or an oxide semiconductor material, the source region TS and the drain region TD in the active layer may be conductive regions doped with ions or impurities to have conductivity.

A gate insulating layer 130 may be disposed on the active layers of the thin-film transistors TFT. The gate insulating layer 130 may be made of an inorganic layer, for example, a silicon nitride layer, a silicon oxynitride layer, a silicon oxide layer, a titanium oxide layer, or an aluminum oxide layer.

A first gate metal layer including gate electrodes TG of the thin-film transistors TFT, first capacitor electrodes CAE1 of capacitors Cst, and scan lines may be disposed on the gate insulating layer 130. The gate electrode TG of each thin-film transistor TFT may overlap the channel region TCH in the third direction (Z-axis direction). The first gate metal layer may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

A first interlayer insulating layer 141 may be disposed on the first gate metal layer. The first interlayer insulating layer 141 may be made of an inorganic layer, for example, a silicon nitride layer, a silicon oxynitride layer, a silicon oxide layer, a titanium oxide layer, or an aluminum oxide layer. The first interlayer insulating layer 141 may include a plurality of inorganic layers.

A second gate metal layer including second capacitor electrodes CAE2 of the capacitors Cst may be disposed on the first interlayer insulating layer 141. The second capacitor electrodes CAE2 may overlap the first capacitor electrodes CAE1 in the third direction (Z-axis direction). Therefore, the first capacitor electrodes CAE1, the second capacitor electrodes CAE2, and inorganic insulating dielectric layers disposed between the first and second capacitor electrodes CAE1 and CAE2 and acting as dielectric layers may form the capacitors Cst. The second gate metal layer may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

A second interlayer insulating layer 142 may be disposed on the second gate metal layer. The second interlayer insulating layer 142 may be made of an inorganic layer, for example, a silicon nitride layer, a silicon oxynitride layer, a silicon oxide layer, a titanium oxide layer, or an aluminum oxide layer. The second interlayer insulating layer 142 may include a plurality of inorganic layers.

A first data metal layer including first connection electrodes CE1 and data lines may be disposed on the second interlayer insulating layer 142. The first connection electrodes CE1 may be connected to the drain regions TD through first contact holes (e.g., first contact openings) CT1 penetrating the gate insulating layer 130, the first interlayer insulating layer 141, and the second interlayer insulating layer 142. The first data metal layer may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

A first organic layer 160 for flattening steps due to the thin-film transistors TFT may be disposed on the first connection electrodes CE1. The first organic layer 160 may be made of an organic layer, such as an acryl resin, an epoxy resin, a phenolic resin, a polyamide resin, or a polyimide resin.

A second data metal layer including second connection electrodes CE2 may be disposed on the first organic layer 160. The second data metal layer may be connected to the first connection electrodes CE1 through second contact holes (e.g., second contact openings) CT2 penetrating the first organic layer 160. The second data metal layer may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

A second organic layer 180 may be disposed on the second connection electrodes CE2. The second organic layer 180 may be made of an organic layer, such as an acryl resin, an epoxy resin, a phenolic resin, a polyamide resin, or a polyimide resin, or polyimide resin.

In some embodiments, the second data metal layer including the second connection electrodes CE2 and the second organic layer 180 may be omitted.

The light emitting element layer EML is disposed on the thin-film transistor layer TFTL. The light emitting element layer EML may include the light emitting elements LEL and a bank 190.

Each of the light emitting elements LEL may include a pixel electrode 171, the light emitting layer 172, and a common electrode 173. Each emission area EA refers to an area at where the pixel electrode 171, the light emitting layer 172, and the common electrode 173 are sequentially stacked so that holes from the pixel electrode 171 and electrons from the common electrode 173 are combined with each other in the light emitting layer 172 to emit light. In the illustrated embodiment, the pixel electrode 171 may be an anode, and the common electrode 173 may be a cathode.

A pixel electrode layer including the pixel electrodes 171 may be formed on the second organic layer 180. The pixel electrodes 171 may be connected to the second connection electrodes CE2 through third contact holes (e.g., third contact openings) CT3 penetrating the second organic layer 180. The pixel electrode layer may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

In a top emission structure in which light is emitted in a direction from the light emitting layers 172 toward the common electrode 173, each of the pixel electrodes 171 may be formed as a single layer of molybdenum (Mo), titanium (Ti), copper (Cu) or aluminum (Al) or, to increase reflectivity, may be formed as a stacked structure of aluminum and titanium (e.g., Ti/Al/Ti), a stacked structure of aluminum and indium tin oxide (e.g., ITO/Al/ITO), an APC alloy, or a stacked structure of an APC alloy and indium tin oxide (e.g., ITO/APC/ITO). The APC alloy is an alloy of silver (Ag), palladium (Pd), and copper (Cu).

The bank 190 defines the emission areas EA of the pixels. To this end, the bank 190 may be formed on the second organic layer 180 to partially expose the pixel electrodes 171. The bank 190 may cover edges of the pixel electrodes 171. The bank 190 may be disposed in the third contact holes CT3. For example, the third contact holes CT3 may be filled with the bank 190. The bank 190 may be an organic resin layer, such as an acryl resin, an epoxy resin, a phenolic resin, a polyamide resin, or a polyimide resin, or polyimide resin.

A spacer 191 may be disposed on the bank 190. The spacer 191 may support a mask during a process of forming the light emitting layers 172. The spacer 191 may be an organic resin layer, such as an acryl resin, an epoxy resin, a phenolic resin, a polyamide resin, or a polyimide resin, or polyimide resin.

The light emitting layers 172 are formed on the pixel electrodes 171. The light emitting layers 172 may include an organic material to emit light of a certain color (e.g., a predetermined color). For example, each of the light emitting layers 172 may include a hole transporting layer, an organic material layer, and an electron transporting layer. The organic material layer may include a host and a dopant. The organic material layer may include a material that emits light and may be formed by using a phosphorescent material or a fluorescent material.

The common electrode 173 is formed on the light emitting layers 172. The common electrode 173 may be formed to cover the light emitting layers 172. The common electrode 173 may be a common layer commonly formed in emission areas EA1 through EA4. A capping layer may be formed on the common electrode 173.

In the top emission structure, the common electrode 173 may be made of a transparent conductive material (TCO) capable of transmitting light, such as indium tin oxide (ITO) or indium zinc oxide (IZO), or may be made of a semi-transmissive conductive material, such as magnesium (Mg), silver (Ag), or an alloy of Mg and Ag. When the common electrode 173 is made of a semi-transmissive metal material, light output efficiency may be increased by a forming a microcavity structure.

The encapsulation layer ENC may be disposed on the light emitting element layer EML. The encapsulation layer ENC may include at least one inorganic layer TFE1 and TFE3 to prevent oxygen or moisture from penetrating into the light emitting element layer EML. In addition, the encapsulation layer ENC may include at least one organic layer TFE2 to protect the light emitting element layer EML from foreign substances, such as dust. For example, the encapsulation layer ENC may include a first encapsulating inorganic layer TFE1, an encapsulating organic layer TFE2, and a second encapsulating inorganic layer TFE3.

The first encapsulating inorganic layer TFE1 may be disposed on the common electrode 173, the encapsulating organic layer TFE2 may be disposed on the first encapsulating inorganic layer TFE1, and the second encapsulating inorganic layer TFE3 may be disposed on the encapsulating organic layer TFE2. Each of the first encapsulating inorganic layer TFE1 and the second encapsulating inorganic layer TFE3 may be a multilayer in which one or more inorganic layers selected from a silicon nitride layer, a silicon oxynitride layer, a silicon oxide layer, a titanium oxide layer, and an aluminum oxide layer are alternately stacked. The encapsulating organic layer TFE2 may be an organic resin layer, such as an acryl resin, an epoxy resin, a phenolic resin, a polyamide resin, or a polyimide resin, or polyimide resin.

The sensor electrode layer SENL may be disposed on the encapsulation layer ENC. The sensor electrode layer SENL may include sensor electrodes TE and RE.

A second buffer layer BF2 may be disposed on the encapsulation layer ENC. The second buffer layer BF2 may include at least one inorganic layer. For example, the second buffer layer BF2 may be a multilayer in which one or more inorganic layers selected from a silicon nitride layer, a silicon oxynitride layer, a silicon oxide layer, a titanium oxide layer, and an aluminum oxide layer are alternately stacked. The second buffer layer BF2 can be omitted.

First connection portions BE1 may be disposed on the second buffer layer BF2. Each of the first connection portions BE1 may be formed as a single layer of molybdenum (Mo), titanium (Ti), copper (Cu) or aluminum (Al) or may be formed as a stacked structure of aluminum and titanium (e.g., Ti/Al/Ti), a stacked structure of aluminum and indium tin oxide (e.g., ITO/Al/ITO), an APC alloy, or a stacked structure of an APC alloy and indium tin oxide (e.g., ITO/APC/ITO).

A first sensor insulating layer TINS1 may be disposed on the first connection portions BE1. The first sensor insulating layer TINS1 may be an inorganic layer, for example, a silicon nitride layer, a silicon oxynitride layer, a silicon oxide layer, a titanium oxide layer, or an aluminum oxide layer.

Sensor electrodes, that is, driving electrodes TE and sensing electrodes RE may be disposed on the first sensor insulating layer TNIS1. In addition, dummy patterns may be disposed on the first sensor insulating layer TNIS1. The driving electrodes TE, the sensing electrodes RE, and the dummy patterns do not overlap the emission areas EA. Each of the driving electrodes TE, the sensing electrodes RE, and the dummy patterns may be formed as a single layer of molybdenum (Mo), titanium (Ti), copper (Cu) or aluminum (Al) or may be formed as a stacked structure of aluminum and titanium (e.g., Ti/Al/Ti), a stacked structure of aluminum and indium tin oxide (e.g., ITO/Al/ITO), an APC alloy, or a stacked structure of an APC alloy and indium tin oxide (e.g., ITO/APC/ITO).

A second sensor insulating layer TINS2 may be disposed on the driving electrodes TE, the sensing electrodes RE, and the dummy patterns. The second sensor insulating layer TINS2 may include at least one of an inorganic layer and an organic layer. The inorganic layer may be a silicon nitride layer, a silicon oxynitride layer, a silicon oxide layer, a titanium oxide layer, or an aluminum oxide layer. The organic layer may be an acryl resin, an epoxy resin, a phenolic resin, a polyamide resin, or a polyimide resin.

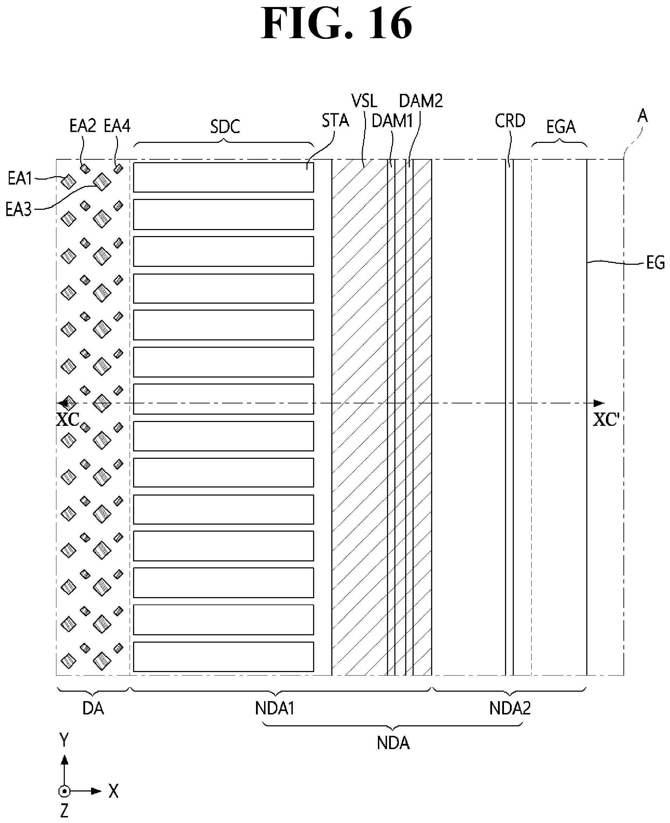

FIG. 16 is an enlarged view of the area A of FIG. 12. FIG. 16 is a plan view illustrating the display area DA and the non-display area NDA disposed on a right side (in FIG. 12) of the display panel 100 according to an embodiment.

Referring to FIG. 16, the display area DA may include a plurality of emission areas EA1 through EA4. The emission areas EA1 through EA4 may include first emission areas EA1 emitting light of a first color, second emission areas EA2 and fourth emission areas EA4 emitting light of a second color, and third emission areas EA3 emitting light of a third color. For example, the light of the first color may be light in a red wavelength band in a range of about 600 nm to about 750 nm, the light of the second color may be light in a green wavelength band in a range of about 480 nm to about 560 nm, and the light of the third color may be light in a blue wavelength band in a range of about 370 nm to about 460 nm, but embodiments of the present invention are not limited thereto.

Although the second emission areas EA2 and the fourth emission areas EA4 emit light of the same color, that is, light of the second color in FIG. 16, embodiments of the present invention are not limited thereto. The second emission areas EA2 and the fourth emission areas EA4 may also emit light of different colors. For example, the second emission areas EA2 may emit light of the second color, and the fourth emission areas EA4 may emit light of a fourth color.

In addition, although each of the first emission areas EA1, the second emission areas EA2, the third emission areas EA3, and the fourth emission areas EA4 is shown as having a rectangular planar shape in FIG. 16, embodiments of the present invention are not limited thereto. Each of the first emission areas EA1, the second emission areas EA2, the third emission areas EA3, and the fourth emission areas EA4 may also have a polygonal shape other than a quadrilateral shape, a circular shape, or an elliptical shape in a plan view.

In addition, as illustrated in FIG. 16, the third emission areas EA3 may be the largest, and the second emission areas EA2 and the fourth emission areas EA4 may be the smallest. The second emission areas EA2 and the fourth emission areas EA4 may be the same size.

The second emission areas EA2 and the fourth emission areas EA4 may be alternately disposed in the first direction (X-axis direction). The second emission areas EA2 may be disposed in (e.g., arranged in) the second direction (Y-axis direction). The fourth emission areas EA4 may be disposed in (e.g., arranged in) the second direction (Y-axis direction).

The first emission areas EA1 and the third emission areas EA3 may be alternately disposed in the first direction (X-axis direction). The first emission areas EA1 may be disposed in the second direction (Y-axis direction). The third emission areas EA3 may be disposed in the second direction (Y-axis direction). Each of the first emission areas EA1 and the third emission areas EA3 may have a square planar shape, but embodiments of the present invention are not limited thereto.

The non-display area NDA includes a first non-display area NDA1 and a second non-display area NDA2. The first non-display area NDA1 may be an area at where structures for driving the pixels of the display area DA are disposed. The second non-display area NDA2 may be disposed outside the first non-display area NDA1. The second non-display area NDA2 may be an edge area of the non-display area NDA. In addition, the second non-display area NDA2 may be an edge area of the display panel 100.

The first non-display area NDA1 may include a scan driving circuit unit SDC, a first power line VSL, a first dam DAM1, and a second dam DAM2.

The scan driving circuit unit SDC may include a plurality of stages STA. The stages STA may be respectively connected to scan lines of the display area DA, which extend in the first direction (X-axis direction). For example, the stages STA may be connected one-to-one (e.g., in one-to-one correspondence) to the scan lines of the display area DA, which extend in the first direction (X-axis direction). The stages STA may sequentially transmit scan signals to the scan lines.

The first power line VSL may be disposed outside the scan driving circuit unit SDC. That is, the first power line VSL may be disposed closer to an edge EG of the display panel 100 than the scan driving circuit unit SDC is. The first power line VSL may extend in the second direction (Y-axis direction) in the non-display area NDA on a right side of the display panel 100.

The first power line VSL may be electrically connected to the common electrode 173. Therefore, the common electrode 173 may receive a first power voltage from the first power line VSL.

The first dam DAM1 and the second dam DAM2 are structures for preventing the encapsulating organic layer TFE2 of the encapsulation layer ENC from overflowing to the edge EG of the display panel 100. The first dam DAM1 and the second dam DAM2 may extend in the second direction (Y-axis direction) in the non-display area NDA on the right side of the display panel 100. The second dam DAM2 may be disposed outside the first dam DAM1 (e.g., may be nearer to the edge EG). The first dam DAM1 may be disposed closer to the scan driving circuit unit SDC than the second dam DAM2 is, and the second dam DAM2 may be disposed closer to the edge EG of the display panel 100 than the first dam DAM1 is.

Although the first dam DAM1 and the second dam DAM2 are shown as being disposed on the first power line VSL in FIG. 16, embodiments of the present invention are not limited thereto. For example, any one of the first dam DAM1 and the second dam DAM2 may not be disposed on (e.g., may be offset from) the first power line VSL. In some embodiments, neither the first dam DAM1 nor the second dam DAM2 may be disposed on the first power line VSL. In such an embodiment, the first dam DAM1 and the second dam DAM2 may be disposed outside the first power line VSL1.

In addition, although the display panel 100 is illustrated as including two dams DAM1 and DAM2 in FIG. 16, embodiments of the present invention are not limited thereto. That is, the display panel 100, in other embodiments, may include three or more dams.

The second non-display area NDA2 may include a crack dam CRD and an edge area EGA.

The crack dam CRD may be a structure for preventing cracks from being generated in (e.g., from forming during) a process of cutting the substrate SUB during the manufacturing process of the display device 10. The crack dam CRD may be an outermost structure on the right side of the display panel 100. The crack dam CRD may extend in the second direction (Y-axis direction) in the non-display area NDA on the right side of the display panel 100.

The edge area EGA may be disposed along the edge EG of the display panel 100. The edge area EGA may be an area where processing traces are generated in the process of cutting the substrate SUB.

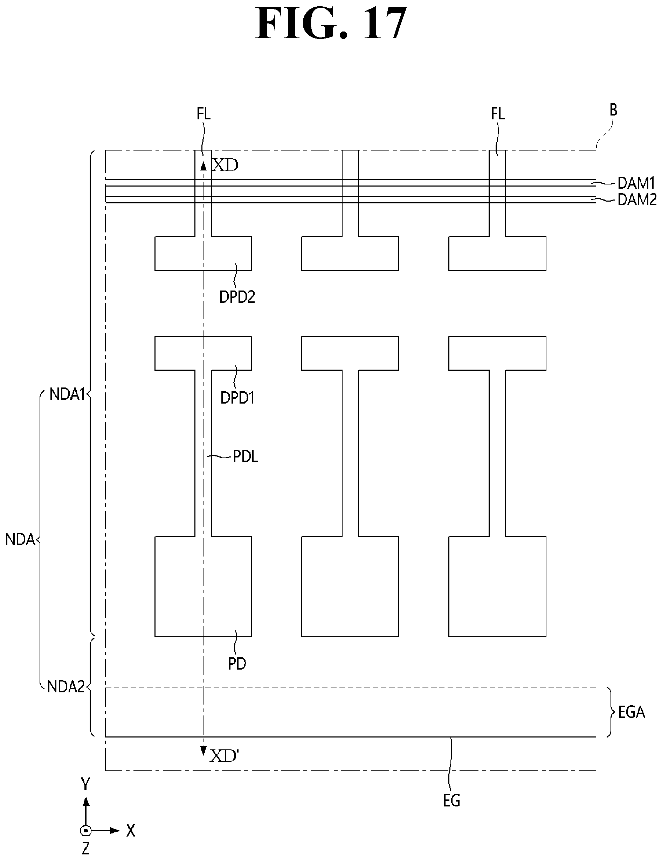

FIG. 17 is an enlarged view of the area B of FIG. 12. FIG. 17 is a plan view illustrating the non-display area NDA disposed on a lower side (in FIG. 12) of the display panel 100 according to an embodiment.

Referring to FIG. 17, the first non-display area NDA1 may include a plurality of display pads PD, a plurality of first driving pads DPD1, a plurality of second driving pads DPD2, a plurality of pad lines PDL, a plurality of fan-out lines FL, the first dam DAM1, and the second dam DAM2.

The display pads PD may be electrically connected to a circuit board 300 through a conductive adhesive member, such as an anisotropic conductive film or an anisotropic conductive adhesive. The display pads PD may be connected to the pad lines PDL, respectively. The pad lines PDL may connect the display pads PD and the first driving pads DPD1 to each other.

The first driving pads DPD1 and the second driving pads DPD2 may be electrically connected to a driving IC 200 through a conductive adhesive member, such as an anisotropic conductive film or an anisotropic conductive adhesive. The first driving pads DPD1 may be input pads through which the driving IC 200 receives signals (e.g., digital video data, a data timing control signal, etc.) of the circuit board 300. The second driving pads DPD2 may be output pads for outputting signals (e.g., data voltages) of the driving IC 200. The second driving pads DPD2 may be connected to the fan-out lines FL, respectively. The fan-out lines FL may connect the second driving pads DPD2 and the data lines of the display area DA to each other.

Each of the first driving pads DPD1 may be disposed closer to the display area DA in the second direction (Y-axis direction) than a display pad PD connected thereto. For example, from among a display pad PD and a first driving pad DPD1 connected to each other, the display pad PD may be disposed closer to the edge EG of the display panel 100 in the second direction (Y-axis direction) than the first driving pad DPD1 is.

Each of the second driving pads DPD2 may be disposed closer to the display area DA in the second direction (Y-axis direction) than any one of the first driving pads DPD1 is. That is, each of the first driving pads DPD1 may be disposed closer to the edge EG of the display panel 100 in the second direction (Y-axis direction) than any one of the second driving pads DPD2 is.

The first dam DAM1 and the second dam DAM2 may cross (e.g., may extend over) the fan-out lines FL. The first dam DAM1 and the second dam DAM2 may extend in the first direction (X-axis direction) in the non-display area NDA on the lower side of the display panel 100. The second dam DAM2 may be disposed outside the first dam DAM1. The first dam DAM1 may be disposed closer to the display area DA than the second dam DAM2, and the second dam DAM2 may be disposed closer to the edge EG of the display panel 100 than the first dam DAM1.

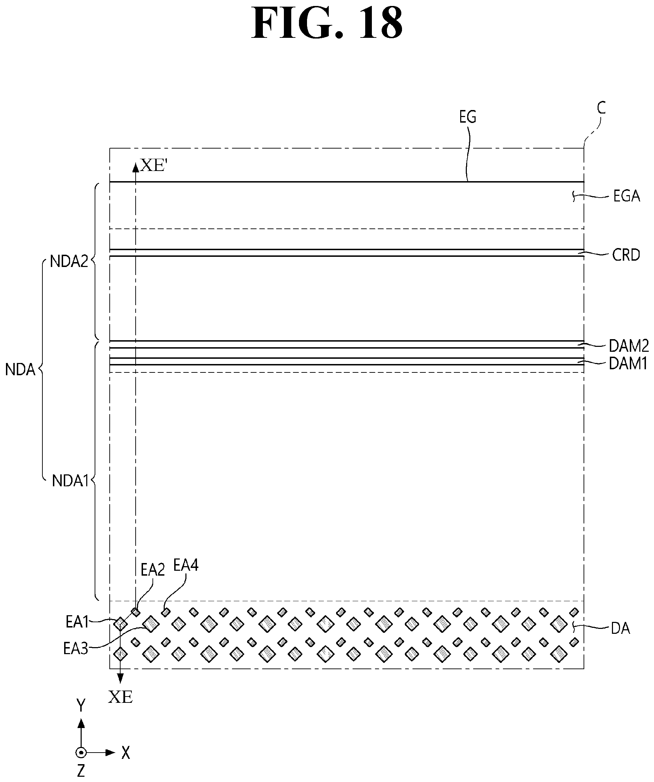

FIG. 18 is an enlarged view of the area C of FIG. 12. FIG. 18 is a plan view illustrating the non-display area NDA disposed on an upper side (in FIG. 12) of the display panel 100 according to an embodiment.

Referring to FIG. 18, the first non-display area NDA1 may include the first dam DAM1 and the second dam DAM2. The first non-display area NDA1 may not include the first power line VSL and the scan driving circuit unit SDC.

The first dam DAM1 and the second dam DAM2 may extend in the first direction (X-axis direction) in the non-display area NDA on the upper side of the display panel 100. The second dam DAM2 may be disposed outside the first dam DAM1. The first dam DAM1 may be disposed closer to the display area DA than the second dam DAM2 is, and the second dam DAM2 may be disposed closer to an edge EG of the display panel 100 than the first dam DAM1 is.

The second non-display area NDA2 may include the crack dam CRD and the edge area EGA.

The crack dam CRD may be an outermost structure on the upper side of the display panel 100. The crack dam CRD may extend in the first direction (X-axis direction) in the non-display area NDA on the upper side of the display panel 100.

The edge area EGA may be disposed along the edge EG of the display panel 100. The edge area EGA may be an area at where processing traces are generated in the process of cutting the substrate SUB.

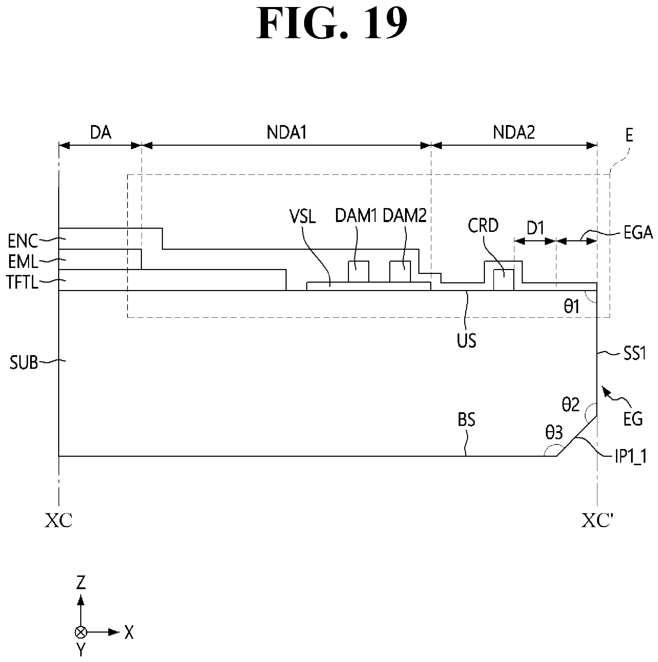

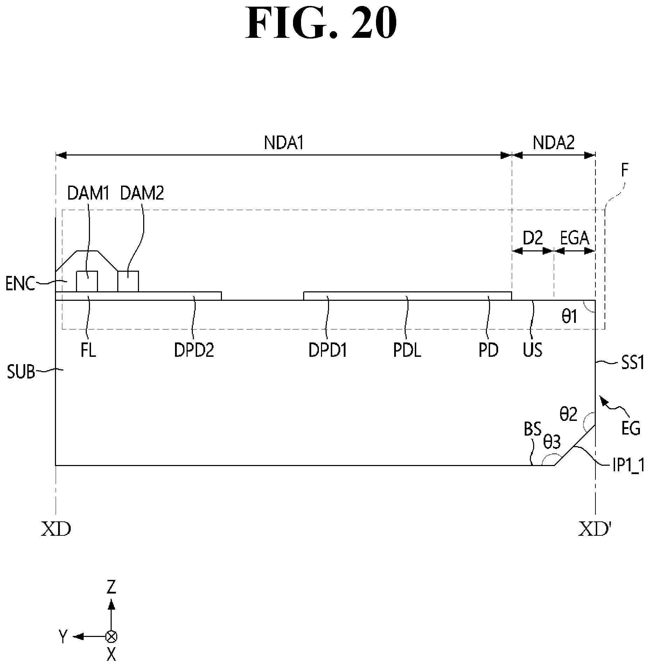

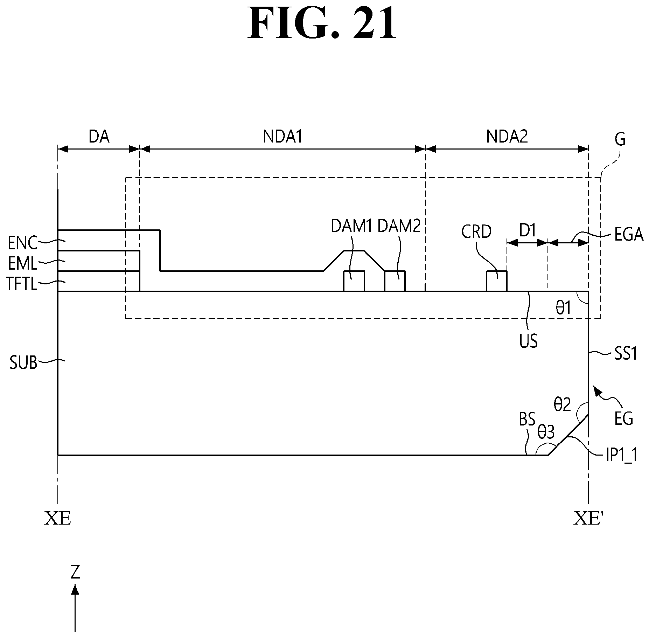

FIG. 19 is a cross-sectional view taken along the line XC-XC' of FIG. 16. FIG. 20 is a cross-sectional view taken along the line XD-XD' of FIG. 17. FIG. 21 is a cross-sectional view taken along the line XE-XE' of FIG. 18.

FIGS. 19 through 21 illustrate cross-sections of the edges EG of the display panel 100 when the substrate SUB of the display panel 100 is cut by spraying an etchant after a laser beam is irradiated by the laser processing apparatus 1 described above with reference to FIG. 1. A side surface of the substrate SUB on the right side in FIG. 19 may be referred to as a first side surface or a right side surface of the substrate SUB. A side surface of the substrate SUB disposed on the right side in FIG. 20 may be referred to as a second side surface or a lower side surface of the substrate SUB. A side surface of the substrate SUB disposed on the right side in FIG. 21 may be referred to as a third side surface or an upper side surface of the substrate SUB.

Referring to FIGS. 19 through 21, the edge area EGA may be an area at where processing traces are formed on an upper surface US of the substrate SUB by an etchant when the substrate SUB is cut by spraying the etchant after a laser beam is irradiated by the laser processing apparatus 1, described above with reference to FIG. 1, etc. The edge area EGA may be equal to or less than 30 μm.

The edge area EGA may have a first inclined surface IP1_1 formed by spraying an etchant after a laser beam is irradiated. An angle θ1 between a side surface SS1 and the upper surface US may be about 90 degrees. That is, the angle θ1 formed by the side surface SS1 and the upper surface US may be substantially close to a right angle (e.g., a vertically intersecting corner). An angle θ2 between the side surface SS1 and the first inclined surface IP1_1 and an angle θ3 between the first inclined surface IP1_1 and a lower surface BS may be obtuse angles. The processing traces formed on the upper surface US of the substrate SUB may overlap the first inclined surface IP1_1 in the third direction (Z-axis direction).

While the processing traces are traces formed by penetration of an etchant between an acid-resistant film and the upper surface US of the substrate SUB in the manufacturing process, the first inclined surface IP1_1 is an inclined surface directly formed by the etchant. Therefore, a width of the edge area EGA in which the processing traces are formed may be smaller than a width of the first inclined surface IP1_1. The width of the edge area EGA refers to a length of the edge area EGA in the first direction (X-axis direction) or in the second direction (Y-axis direction). The width of the first inclined surface IP1_1 refers to a length of the first inclined surface IP1_1 in the first direction (X-axis direction) or in the second direction (Y-axis direction).

The crack dam CRD may be a structure for preventing cracks from being generated in the process of cutting the substrate SUB during the manufacturing process of the display device 10. The crack dam CRD may be an outermost structure on the right side of the display panel 100. A distance D1 between the crack dam CRD and the edge area EGA may be about 30 μm or less. The distance D1 between the crack dam CRD and the edge area EGA may be about 0 μm.

A minimum distance from the crack dam CRD to the edge EG of the display panel 100 may be the sum of the width of the edge area EGA and the minimum distance D1 from the crack dam CRD to the edge area EGA. For example, the minimum distance D1 from the crack dam CRD, which is the outermost structure, to the edge area EGA may be about 30 μm or less.

When the substrate SUB is cut by spraying an etchant after irradiating a laser beam, the minimum distance between the crack dam CRD and the edge EG of the display panel 100 may vary according to a unilateral tolerance of the laser beam. For example, when the unilateral tolerance of the laser beam is about 50 μm, the distance D1 between the crack dam CRD and the edge area EGA may be, at least, about 50 μm or less and, at most, about 150 μm or less.

A minimum distance from a display pad PD to the edge EG of the substrate SUB may be the sum of the width of the edge area EGA and a minimum distance D2 from the display pad PD to the edge area EGA. For example, the minimum distance from the display pad PD, which is an outermost structure, to the edge EG of the display panel 100 may be about 80 μm or less.

When the substrate SUB is cut by spraying an etchant after irradiating a laser beam, the minimum distance from the display pad PD to the edge EG of the substrate SUB may vary according to a unilateral tolerance of the laser beam. For example, when the unilateral tolerance of the laser beam is about 50 μm, the minimum distance from the display pad PD to the edge EG of the display panel 100 may be about 130 μm or less.

In addition, when the substrate SUB of the display panel 100 is cut by spraying an etchant after irradiating a laser beam during the manufacturing process of the display panel 100, the side surface SS1 and the first inclined surface IP1_1 of the display panel 100 may be etched by the etchant. In such an embodiment, the roughness of the side surface SS1 and the first inclined surface IP1_1 of the display panel 100 may be about 0.5 μm or less.

The roughness of the side surface SS1 and the first inclined surface IP1_1 of the display panel 100 when the substrate SUB of the display panel 100 is cut by spraying an etchant after irradiating a laser beam may be smaller than the roughness of a cut surface of the display panel 100 when the substrate SUB is cut using a cutting member and then a polishing process is performed.

When the substrate SUB of the display panel 100 is cut by spraying an etchant after irradiating a laser beam, the minimum distance from the crack dam CRD to the edge EG of the display panel 100 may be reduced. Therefore, when the substrate SUB of the display panel 100 is cut by spraying an etchant after irradiating a laser beam, a width of the second non-display area NDA2 may be greatly reduced. That is, a width of the non-display area NDA can be minimized.

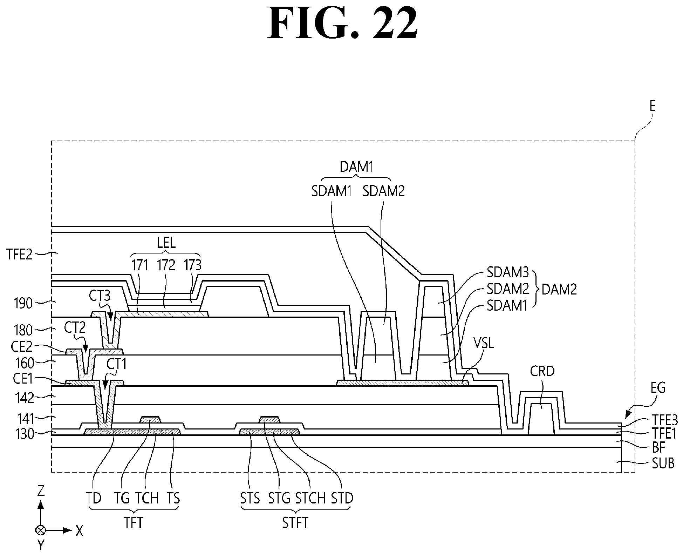

FIG. 22 is an enlarged view of the area E of FIG. 19.

Referring to FIG. 22, the crack dam CRD may include the same material as the first organic layer 160. The crack dam CRD may be disposed on the buffer layer BF. The crack dam CRD may be made of an organic layer, such as an acryl resin, an epoxy resin, a phenolic resin, a polyamide resin, or a polyimide resin, or polyimide resin.

Although the crack dam CRD is shown as including one organic layer in FIG. 22, embodiments of the present invention are not limited thereto. For example, the crack dam CRD may include another organic layer including the same material as the second organic layer 180. In other embodiments, the crack dam CRD may include another organic layer including the same material as the bank 190. In other embodiments, the crack dam CRD may include another organic layer including the same material as the spacer 191 (see, e.g., FIG. 15).

The first power line VSL may include the same material as the first data metal layer including the first connection electrodes CE1 and the data lines and may be disposed on the same layer as the first data metal layer. The first power line VSL may be disposed on the second interlayer insulating layer 142. The first power line VSL may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The first dam DAM1 and the second dam DAM2 may be disposed on the first power line VSL. The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 may include the same material as the first organic layer 160 and may be disposed on the same layer as the first organic layer 160. The second sub-dam SDAM2 may include the same material as the second organic layer 180 and may be disposed on the same layer as the second organic layer 180. The third sub-dam SDAM3 may include the same material as the bank 190 and may be disposed on the same layer as the bank 190.

A height of the first dam DAM1 may be lower than a height of the second dam DAM2, but embodiments of the present invention are not limited thereto. The height of the first dam DAM1 may also be substantially equal to or higher than the height of the second dam DAM2.

The common electrode 173 may be connected to the first power line VSL at where it is exposed without being covered by the first organic layer 160, the second organic layer 180, and the first dam DAM1. Therefore, the common electrode 173 may receive the first power voltage of the first power line VSL.

The first encapsulating inorganic layer TFE1 may cover the first dam DAM1, the second dam DAM2, and the crack dam CRD in the non-display area NDA on the right side of the display panel 100. The first encapsulating inorganic layer TFE1 may extend adjacent to the edge EG of the display panel 100 in the non-display area NDA on the right side of the display panel 100. A side of the first encapsulating inorganic layer TFE1 may be aligned with a side of the substrate SUB.

The encapsulating organic layer TFE2 may cover an upper surface of the first dam DAM1 and may not cover an upper surface of the second dam DAM2. However, embodiments of the present invention are not limited thereto. The encapsulating organic layer TFE2 may also not cover both the upper surface of the first dam DAM1 and the upper surface of the second dam DAM2. The encapsulating organic layer TFE2 may not overflow to the edge EG of the display panel 100 due to the first dam DAM1 and the second dam DAM2.

The second encapsulating inorganic layer TFE3 may cover the first dam DAM1, the second dam DAM2, and the crack dam CRD in the non-display area NDA on the right side of the display panel 100. The second encapsulating inorganic layer TFE3 may extend adjacent to the edge EG of the display panel 100 in the non-display area NDA on the right side of the display panel 100. A side of the second encapsulating inorganic layer TFE3 may be aligned with the side of the substrate SUB.

An inorganic encapsulation area in which the first encapsulating inorganic layer TFE1 and the second encapsulating inorganic layer TFE3 contact each other may be formed from the second dam DAM2 to the edge EG of the display panel 100. The inorganic encapsulation area may surround (e.g., may extend around a periphery of) the second dam DAM2.

In FIG. 22, a scan thin-film transistor STFT of the scan driving circuit unit SDC is shown as an example. Because the scan thin-film transistor STFT is substantially the same as the thin-film transistors TFT described with reference to FIG. 15, a repeated description of the scan thin-film transistor STFT will be omitted.

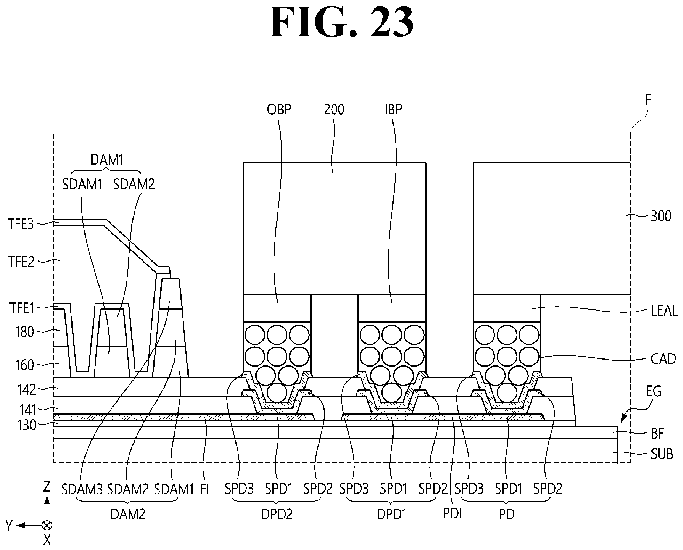

FIG. 23 is an enlarged view of the area F of FIG. 20.

Referring to FIG. 23, each of a display pad PD, a first driving pad DPD1, and a second driving pad DPD2 may include a first sub-pad SPD1, a second sub-pad SPD2, and a third sub-pad SPD3.

The first sub-pad SPD1 may include the same material as the first gate metal layer including the gate electrodes TG, the first capacitor electrodes CAE1 of the capacitors Cst, and the scan lines and may be disposed on the same layer as the first gate metal layer. The first sub-pad SPD1 may be disposed on the gate insulating layer 130. The first sub-pad SPD1 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The second sub-pad SPD2 may include the same material as the second gate metal layer including the second capacitor electrodes CAE2 and may be disposed on the same layer as the second gate metal layer. The second sub-pad SPD2 may be disposed on the first interlayer insulating layer 141. The second sub-pad SPD2 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The third sub-pad SPD3 may include the same material as the first data metal layer including the first connection electrodes CE1 and the data lines and may be disposed on the same layer as the first data metal layer. The third sub-pad SPD3 may be disposed on the second interlayer insulating layer 142. The third sub-pad SPD3 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The third sub-pad SPD3 of the display pad PD may be electrically connected to a lead line LEAL of a circuit board 300 through a conductive adhesive CAD member, such as an anisotropic conductive film or an anisotropic conductive adhesive. The third sub-pad SPD3 of the first driving pad DPD1 may be electrically connected to an input bump IBP of a driving IC 200 through a conductive adhesive member CAD, such as an anisotropic conductive film or an anisotropic conductive adhesive. The third sub-pad SPD3 of the second driving pad DPD2 may be electrically connected to an output bump OBP of a driving IC 200 through a conductive adhesive member CAD, such as an anisotropic conductive film or an anisotropic conductive adhesive.

The first encapsulating inorganic layer TFE1 and the second encapsulating inorganic layer TFE3 may cover the first dam DAM1 and a portion of the second dam DAM2. For example, the first encapsulating inorganic layer TFE1 and the second encapsulating inorganic layer TFE3 may not cover a portion of the upper surface of the second dam DAM2. In other embodiments, the first encapsulating inorganic layer TFE1 and the second encapsulating inorganic layer TFE3 may completely cover the first dam DAM1 and the second dam DAM2 but, in such an embodiment, may not cover the third sub-pad SPD3 of the second driving pad DPD2. That is, the first encapsulating inorganic layer TFE1 and the second encapsulating inorganic layer TFE3 may not extend to the display pad PD, the first driving pad DPD1, and the second driving pad DPD2 disposed adjacent to the edge EG of the display panel 100.

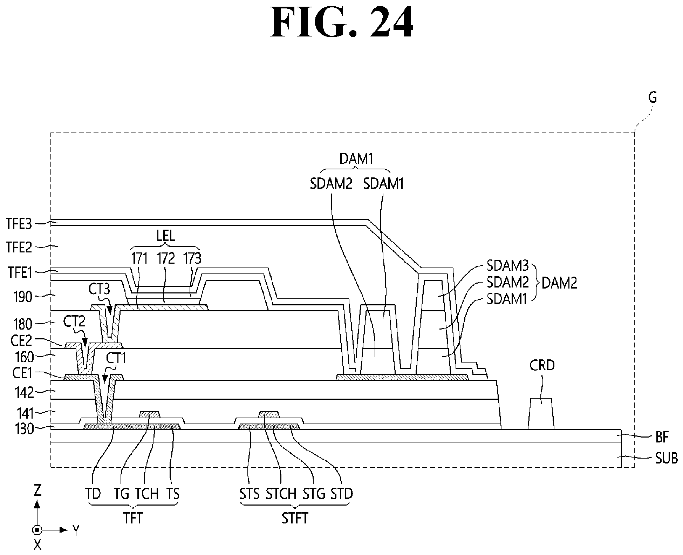

FIG. 24 is an enlarged view of the area G of FIG. 21.

Referring to FIG. 24, the first encapsulating inorganic layer TFE1 and the second encapsulating inorganic layer TFE3 may not cover the crack dam CRD in the non-display area NDA on the upper side of the display panel 100. That is, in the non-display area NDA on the upper side of the display panel 100, the first encapsulating inorganic layer TFE1 and the second encapsulating inorganic layer TFE3 may not extend to the edge EG of the display panel 100.

In addition, in the non-display area NDA on the left and right sides of the display panel 100 as well as in the non-display area NDA on the upper side of the display panel 100, the first encapsulating inorganic layer TFE1 and the second encapsulating inorganic layer TFE3 may not cover the crack dam CRD. That is, in the non-display area NDA on the left and right sides of the display panel 100 as well as in the non-display area NDA on the upper side of the display panel 100, the first encapsulating inorganic layer TFE1 and the second encapsulating inorganic layer TFE3 may not extend to the edge EG of the display panel 100.

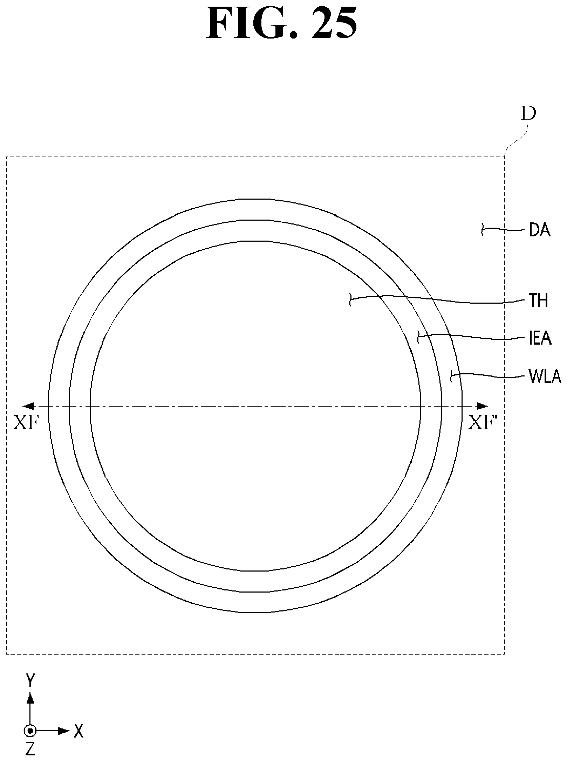

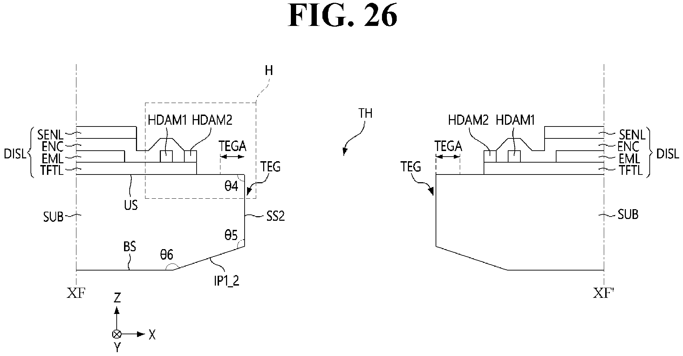

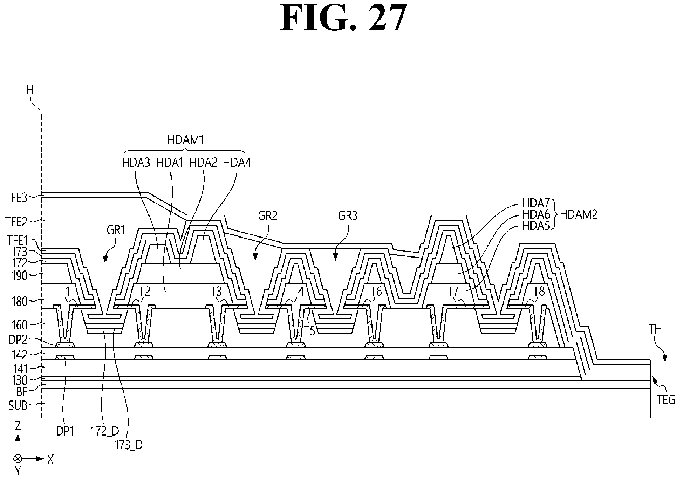

FIG. 25 is an enlarged view of the area D of FIG. 12. FIG. 26 is a cross-sectional view taken along the line XF-XF' of FIG. 25. FIG. 27 is an enlarged view of the area H of FIG. 26.

Referring to FIGS. 25 through 27, the display panel 100, according to an embodiment, has an inorganic encapsulation area IEA surrounding (e.g., extending around a periphery of) the through hole TH and a wiring area WLA surrounding the inorganic encapsulation area IEA.

The inorganic encapsulation area IEA may be a layer at where the first encapsulating inorganic layer TFE1 and the second encapsulating inorganic layer TFE3 of the encapsulation layer ENC contact each other to prevent penetration of oxygen or moisture into the light emitting element layer EML of the display layer DISL due to the through hole TH.

The inorganic encapsulation area IEA may include at least one dam, at least one tip, and at least one groove. For example, as illustrated in FIG. 27, the inorganic encapsulation area IEA may include a first hole dam HDAM1, a second hole dam HDAM2, first through eighth tips T1 through T8, and first through third grooves GR1 through GR3.

The first tip T1 and the second tip T2 may be disposed closer to the wiring area WLA than the first hole dam HDAM1. The first tip T1 may be disposed closer to the wiring area WLA than the second tip T2. The second tip T2 may be disposed between the first tip T1 and the first hole dam HDAM1.

The third tip T3, the fourth tip T4, the fifth tip T5, and the sixth tip T6 may be disposed between the first hole dam HDAM1 and the second hole dam HDAM2. At least a portion of the third tip T3 may overlap the first hole dam HDAM1 in the third direction (Z-axis direction).

The seventh tip T7 and the eighth tip T8 may be disposed closer to the through hole TH than the second hole dam HDAM2. At least a portion of the seventh tip T7 may overlap the second hole dam HDAM2 in the third direction (Z-axis direction). A distance between the eighth tip T8 and the through hole TH may be about 50 $\mu$m.

The first groove GR1 may be disposed between the first tip T1 and the second tip T2. The second groove GR2 may be disposed between the third tip T3 and the fourth tip T4. The third groove GR3 may be disposed between the fifth tip T5 and the sixth tip T6.

The wiring area WLA may be an area where bypass lines, due to the through hole TH, are disposed. Some of the bypass lines may be connected to the data lines, and some other ones of the bypass lines may be connected to a second power line to which a second power voltage higher than the first power voltage is applied. Some other ones of the bypass lines may be connected to the scan lines. The wiring area WLA may be surrounded by the display area DA (e.g., the wiring area WLA may be embedded in or formed in the display area DA).

FIG. 26 shows a cross-section of an edge TEG of the through hole TH when the substrate SUB of the display panel 100 is cut by spraying an etchant after irradiating a laser beam by using the laser processing apparatus 1, described above with reference to FIG. 1, etc.

Referring to FIG. 26, a through-hole edge area TEGA may be an area at where processing traces are formed on the upper surface US of the substrate SUB by an etchant when the substrate SUB is cut by spraying the etchant after irradiating a laser beam by using the laser processing apparatus 1, described above with reference to FIG. 1, etc. The through-hole edge area TEGA may be equal to or less than 30 $\mu$m.

The through-hole edge area TEGA may include a second inclined surface IP1_2 formed by spraying an etchant after irradiating a laser beam. An angle θ4 formed between a side surface SS2 of the edge TEG of the through hole TH and the upper surface US may be about 90 degrees. That is, the angle θ4 formed between the side surface SS2 of the edge TEG of the through hole TH and the upper surface US may be substantially close to a right angle. An angle θ5 formed between the side surface SS2 of the edge TEG of the through hole TH and the second inclined surface IP1_2 and an angle θ6 formed between the second inclined surface IP1_2 and the lower surface BS may be obtuse angles. The processing traces formed on the upper surface US of the substrate SUB may overlap the second inclined surface IP1_2 in the third direction (Z-axis direction).

The angle θ5 formed between the side surface SS2 of the edge TEG of the through hole TH and the second inclined surface IP1_2 and the angle θ6 formed between the second inclined surface IP1_2 and the lower surface BS may vary according to the depth of a laser irradiation area formed by a laser beam when the substrate SUB of the display panel 100 is cut by spraying an etchant after irradiating the laser beam. The depth of a laser irradiation area formed by a laser beam to cut along the edge EG (see, e.g., FIG. 19, etc.) of the display panel 100 may be different from the depth of a laser irradiation area formed by a laser beam to cut along the edge TEG of the through hole TH.

The angle θ5 formed between the side surface SS2 of the edge TEG of the through hole TH and the second inclined surface IP1_2 illustrated in FIG. 26 may be smaller than the angle θ2 formed between the side surface SS1 and the first inclined surface IP1_1 illustrated in FIGS. 19 through 21. The angle θ6 formed between the second inclined surface IP1_2 and the lower surface BS illustrated in FIG. 26 may be smaller than the angle θ3 formed between the first inclined surface IP1_1 and the lower surface BS illustrated in FIGS. 19 through 21.

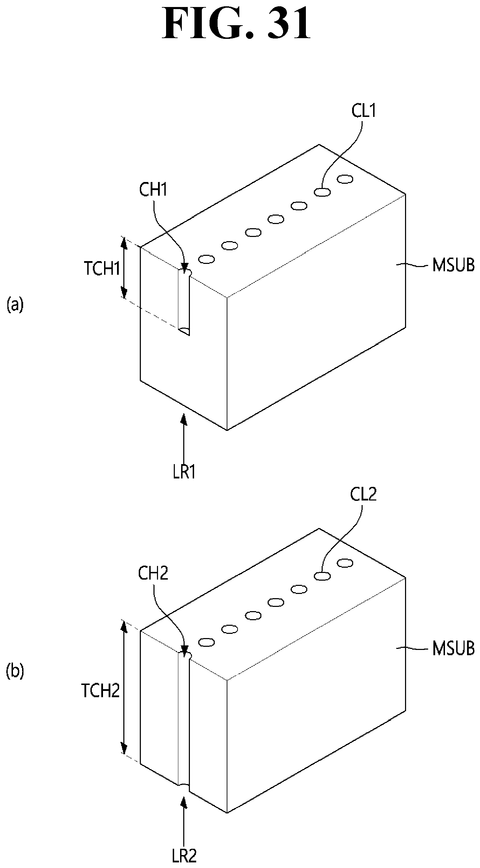

The depth of the laser irradiation area formed by a laser beam to cut along the edge EG of the display panel 100 and the depth of the laser irradiation area formed by a laser beam to cut along the edge TEG of the through hole TH will be described in more detail later with reference to FIG. 31.

Referring to FIG. 27, first dummy patterns DP1 may include the same material as the second gate metal layer including the second capacitor electrodes CAE2 of the capacitors Cst and may be disposed on the same layer as the second gate metal layer. For example, the first dummy patterns DP1 may be disposed on the first interlayer insulating layer 141. Each of the first dummy patterns DP1 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

Second dummy patterns DP2 may include the same material as the first data metal layer including the first connection electrodes CE1 and the data lines and may be disposed on the same layer as the first data metal layer. For example, the second dummy patterns DP2 may be disposed on the second interlayer insulating layer 142. Each of the second dummy patterns DP2 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The second dummy patterns DP2 may overlap the first dummy patterns DP1 in the third direction (Z-axis direction).

The first through eighth tips T1 through T8 may include the same material as the second data metal layer including the second connection electrodes CE2 and may be disposed on the same layer as the second data metal layer. For example, the first through eighth tips T1 through T8 may be disposed on the first organic layer 160. Each of the first through eighth tips T1 through T8 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The first through eighth tips T1 through T8 may be respectively connected to the second dummy patterns DP2 through contact holes (e.g., contact openings) penetrating the first organic layer 160. Each of the first through eighth tips T1 through T8 may include an eave structure having upper and lower surfaces exposed without being covered by the first organic layer 160, the second organic layer 180, the first hole dam HDAM1, and the second hole dam HDAM2. The fourth tip T4 and the fifth tip T5 may be integrally formed with each other. Each of the first through eighth tips T1 through T8 may be a protruding pattern or a trench pattern for forming a groove (or trench). The eighth tip T8 may be an outermost structure adjacent to the edge TEG of the through hole TH. Although the eighth tip T8 is illustrated as an outermost structure adjacent to the edge TEG of the through hole TH in FIG. 27, embodiments of the present invention are not limited thereto. For example, in an embodiment in which the seventh tip T7 and the eighth tip T8 are omitted, the outermost structure adjacent to the edge TEG of the through hole TH may be the second hole dam HDAM2 for preventing the overflow of the encapsulating organic layer TFE2 of the encapsulation layer ENC. In another embodiment, when the seventh tip T7 and the eighth tip T8 are omitted, the outermost structure adjacent to the edge TEG of the through hole TH may be a groove for breaking (e.g., separating) the light emitting layer 172 and the common electrode 173.

A distance from the eighth tip T8 to the edge TEG of the through hole TH may be about 300 $\mu$m. The through-hole edge area TEGA may be disposed between the eighth tip T8 and the edge TEG of the through hole TH.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have eave structures formed by the first tip T1 and the second tip T2, the second groove GR2 may have eave structures formed by the third tip T3 and the fourth tip T4, and the third groove GR3 may have eave structures formed by the fifth tip T5 and the sixth tip T6.

When the light emitting layer 172 is deposited by evaporation and the common electrode 173 is deposited by sputtering, the light emitting layer 172 and the common electrode 173 may have relatively low (or poor) step coverage and, thus, may be broken (or separated) by each of the first through third grooves GR1 through GR3. When the first encapsulating inorganic layer TFE1 and the third encapsulating inorganic layer TFE3 are deposited by chemical vapor deposition or atomic layer deposition, they may have a relatively high (or good) step coverage and, thus, may be continuously formed without being broken (or separated) by each of the first through third grooves GR1 through GR3. The step coverage refers to the ratio of the degree of thin-film coating on an inclined portion to the degree of thin-film coating on a flat portion. A light emitting layer fragment 172_D separated from the light emitting layer 172 (e.g., a disconnected portion of the light emitting layer) and a common electrode fragment 173_D separated from the common electrode 173 (e.g., a disconnected portion of the common electrode) may be disposed in each of the first through third grooves GR1 through GR3.

The first hole dam HDAM1 may include first through fourth sub-dams HDA1 through HDA4. The first sub-dam HDA1 may be disposed on the first organic layer 160 and may include the same material as the second organic layer 180. The first sub-dam HDA1 may be disposed on the second tip T2 and the third tip T3. The second sub-dam HDA2 may be disposed on the first sub-dam HDA1 and may include the same material as the bank 190. The third sub-dam HDA3 and the fourth sub-dam HDA4 may be disposed on the second sub-dam HDA2 and may include the same material as the spacer 191, but embodiments of the present invention are not limited thereto. The fourth sub-dam HDA4 may be disposed closer to the through hole TH than the third sub-dam HDA3 is. A thickness of the fourth sub-dam HDA4 may be greater than that of the third sub-dam HDA3.

The second hole dam HDAM2 may include fifth through seventh sub-dams HDA5 through HDA7. The fifth sub-dam HDA5 may be disposed on the first organic layer 160 and may include the same material as the second organic layer 180. The fifth sub-dam HDA5 may be disposed on the seventh tip T7. The sixth sub-dam HDA6 may be disposed on the fifth sub-dam HDA5 and may include the same material as the bank 190. The seventh sub-dam HDA7 may be disposed on the sixth sub-dam HDA6 and may include the same material as the spacer 191, but embodiments of the present invention are not limited thereto.

The first hole dam HDAM1 and the second hole dam HDAM2 may prevent the encapsulating organic layer TFE2 from overflowing to the through hole TH.

The light emitting layer fragment 172_D, the common electrode fragment 173_D, the first encapsulating inorganic layer TFE1, and the second encapsulating inorganic layer TFE3 may extend to the edge TEG of the through hole TH. An end of the light emitting layer fragment 172_D, an end of the common electrode fragment 173_D, an end of the first encapsulating inorganic layer TFE1, or an end of the second encapsulating inorganic layer TFE3 may match (e.g., may terminate at) the edge TEG of the through hole TH.

As illustrated in FIG. 27, because the light emitting layer 172 and the common electrode 173 are broken at each of the first through third grooves GR1 through GR3 formed by the first through eighth tips T1 through T8, the light emitting layer 172 and the common electrode 173 may not be exposed to the through hole TH, thereby preventing formation of a path through which oxygen and moisture are introduced.

FIG. 28 is a detailed cross-sectional view taken along the lines XA-XA' and XB-XB' of FIG. 11. FIG. 29 is a cross-sectional view illustrating the display device 10 shown in FIG. 28 in a bent state. FIGS. 28 and 29 illustrate the display device 10 shown in FIGS. 13 and 14 in more detail. In addition, an embodiment in which the substrate SUB includes the first substrate SUB1 and the second substrate SUB2 is illustrated.

Referring to FIGS. 28 and 29, the substrate SUB may include the rigid first substrate SUB1 and the second substrate SUB2, which is made of polymer resin and is ductile (or flexible).

The first substrate SUB1 may be made of ultra-thin glass having a thickness of about 500 $\mu$m or less, but embodiments of the present invention are not limited thereto. The first substrate SUB1 may include a first sub-substrate SSUB1 disposed in the display area DA and a second sub-substrate SSUB2 disposed in the pad area PDA.

The second substrate SUB2 may be made of polymer resin having a thickness smaller than that of the first substrate SUB1. For example, the second substrate SUB2 may be made of an organic material, such as an acryl resin, an epoxy resin, a phenolic resin, a polyamide resin, or a polyimide resin, or polyimide resin. When the second substrate SUB2 is made of polymer resin, it may be referred to as a plastic substrate. In another embodiment, when the second substrate SUB2 is made of an organic material, it may be referred to as an organic layer.

The first substrate SUB1 may not be disposed in the bending area BA. Thus, because the bending area BA includes the ductile second substrate SUB2, it can be easily bent.

The thin-film transistor layer TFTL may be disposed in the display area DA, the bending area BA, and the pad area PDA.

A protective layer PRTL may be disposed on the thin-film transistor layer TFTL in the bending area BA. The protective layer PRTL may protect the thin-film transistor layer TFTL exposed to the outside in the bending area BA. The protective layer PRTL may be made of an organic material, such as an acryl resin, an epoxy resin, a phenolic resin, a polyamide resin, or a polyimide resin.

A cross-sectional shape of the substrate SUB at an edge BEG of the bending area BA may be substantially the same as a cross-sectional shape of the substrate SUB at the edge EG of the display panel 100. The cross-sectional shape of the substrate SUB at the edge BEG of the bending area BA may be different from a cross-sectional shape of the substrate SUB at the edge TEG of the through hole TH. The cross-sectional shape of the substrate SUB at the edge EG of the display panel 100 may be different from the cross-sectional shape of the substrate SUB at the edge TEG of the through hole TH.

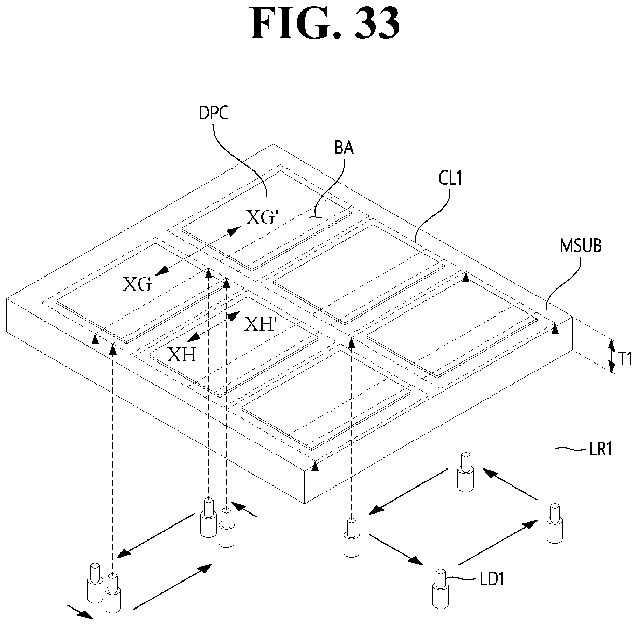

As in operation S130 of FIGS. 30 and 33, which will be described in more detail later, when the edge EG of the display panel 100 is formed by spraying an etchant after irradiating a first laser beam LR1, the first substrate SUB1 may have the side surface SS1 and the first inclined surface IP1_1 at the edge EG of the display panel 100. The angle $\theta 1$ formed between the side surface SS1 and the upper surface US at the edge EG of the display panel 100 may be about 90 degrees. The angle $\theta 2$ formed between the side surface SS1 and the first inclined surface IP1_1 at the edge EG of the display panel 100 and the angle $\theta 3$ formed between the first inclined surface IP1_1 and the lower surface BS may be obtuse angles.

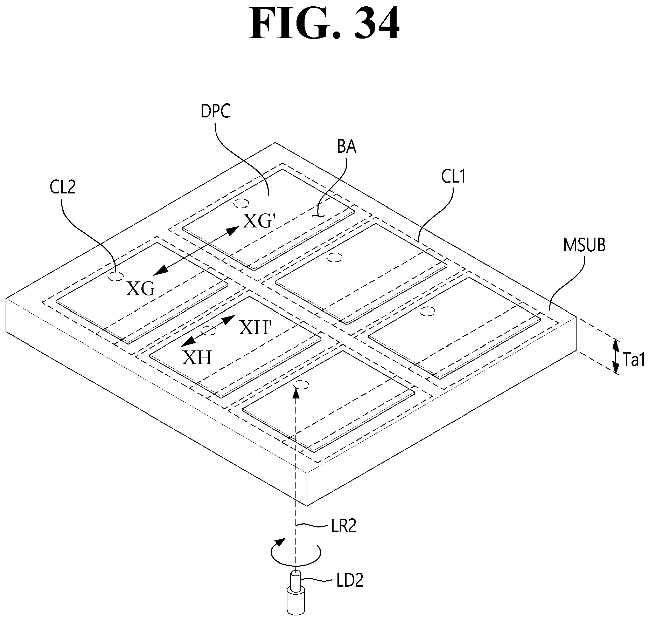

As in operation S140 of FIGS. 30 and 34, which will be described in more detail later, when the edge TEG of the through hole TH is formed by spraying an etchant after irradiating a second laser beam LR2, the first substrate SUB1 may include the side surface SS2 and the second inclined surface IP1_2 at the edge TEG of the through hole TH. The angle $\theta 4$ formed between the side surface SS2 of the edge TEG of the through hole TH and the upper surface US may be about 90 degrees. The angle $\theta 5$ formed between the side surface SS2 of the edge TEG of the through hole TH and the second inclined surface IP1_2 and the angle $\theta 6$ formed between the second inclined surface IP1_2 and the lower surface BS may be obtuse angles.

As illustrated in FIG. 31, which will be described in more detail later, because a depth (e.g., a sketch length) of first laser irradiation areas CH1 formed by the first laser beam LR1 is different from a depth (e.g., a sketch length) of second laser irradiation areas CH2 formed by the second laser beam LR2, a cross-sectional shape of the side surface SS1 and the first inclined surface IP1_1 of the edge EG of the display panel 100 may be different from a cross-sectional shape of the side surface SS2 and the second inclined surface IP1_2 of the edge TEG of the through hole TH.

For example, a length of the side surface SS1 of the edge EG of the display panel 100 in the third direction (Z-axis direction) may be greater than a length of the side surface SS2 of the edge TEG of the through hole TH in the third direction (Z-axis direction). A length of the first inclined surface IP1_1 of the edge EG of the display panel 100 in an inclination direction may be smaller than a length of the second inclined surface IP1_2 of the edge TEG of the through hole TH in the inclination direction.

In addition, the angle $\theta 2$ formed between the side surface SS1 and the first inclined surface IP1_1 at the edge EG of the display panel 100 may be greater than the angle $\theta 5$ formed between the side surface SS2 and the second inclined surface IP1_2 at the edge TEG of the through hole TH. In addition, the angle $\theta 3$ formed between the first inclined surface IP1_1 and the lower surface BS at the edge EG of the display panel 100 may be smaller than the angle $\theta 6$ formed between the second inclined surface IP1_2 and the lower surface BS at the edge TEG of the through hole TH.

In some embodiments, the edge BEG of the bending area BA may be formed in the same manufacturing process as the edge EG of the display panel 100. For example, when the edge BEG of the bending area BA is formed by spraying an etchant after irradiating the first laser beam LR1 (see, e.g., FIG. 33), the first substrate SUB1 may have a side surface SS3 and a third inclined surface IP1_3 at the edge BEG of the bending area BA. An angle $\theta 7$ formed between the side surface SS3 and the upper surface US at the edge BEG of the bending area BA may be about 90 degrees. An angle $\theta 8$ formed between the side surface SS3 and the third inclined surface IP1_3 and an angle $\theta 9$ formed between the third inclined surface IP1_3 and the lower surface BS at the edge BEG of the bending area BA may be obtuse angles.

In such an embodiment, a length of the side surface SS3 at the edge BEG of the bending area BA in the third direction (Z-axis direction) may be substantially equal to the length of the side surface SS1 of the edge EG of the display panel 100 in the third direction (Z-axis direction). A length of the third inclined surface IP1_3 at the edge BEG of the bending area BA in an inclination direction may be substantially equal to the length of the first inclined surface IP1_1 of the edge EG of the display panel 100 in the inclination direction.

In addition, the length of the side surface SS3 at the edge BEG of the bending area BA in the third direction (Z-axis direction) may be greater than the length of the side surface SS2 at the edge TEG of the through hole TH in the third direction (Z-axis direction). The length of the third inclined surface IP1_3 at the edge BEG of the bending area BA in an inclination direction may be smaller than the length of the second inclined surface IP1_2 at the edge TEG of the through hole TH in the inclination direction.

In addition, the angle $\theta 8$ formed between the side surface SS3 and the third inclined surface IP1_3 at the edge BEG of the bending area BA may be substantially equal to the angle $\theta 2$ formed between the side surface SS1 and the first inclined surface IP1_1 at the edge EG of the display panel 100. In addition, the angle $\theta 9$ formed between the third inclined surface IP1_3 and the lower surface BS at the edge BEG of the bending area BA may be substantially equal to the angle $\theta 3$ formed between the first inclined surface IP1_1 and the lower surface BS at the edge EG of the display panel 100.

In addition, the angle θ8 formed between the side surface SS3 and the third inclined surface IP1_3 at the edge BEG of the bending area BA may be greater than the angle θ5 formed between the side surface SS2 and the second inclined surface IP1_2 at the edge TEG of the through hole TH. In addition, the angle θ9 formed between the third inclined surface IP1_3 and the lower surface BS at the edge BEG of the bending area BA may be smaller than the angle θ6 formed between the second inclined surface IP1_2 and the lower surface BS at the edge TEG of the through hole TH.

In an embodiment, the edge BEG of the bending area BA may also be formed in the same manufacturing process as the edge TEG of the through hole TH. In such an embodiment, the shape of the edge BEG of the bending area BA, such as the length of the side surface of the edge BEG of the bending area BA and the angle of the inclined surface, may be the same as the shape of the edge TEG of the through hole TH.

A method of manufacturing a display device by using a laser processing apparatus according to an embodiment will now be described.

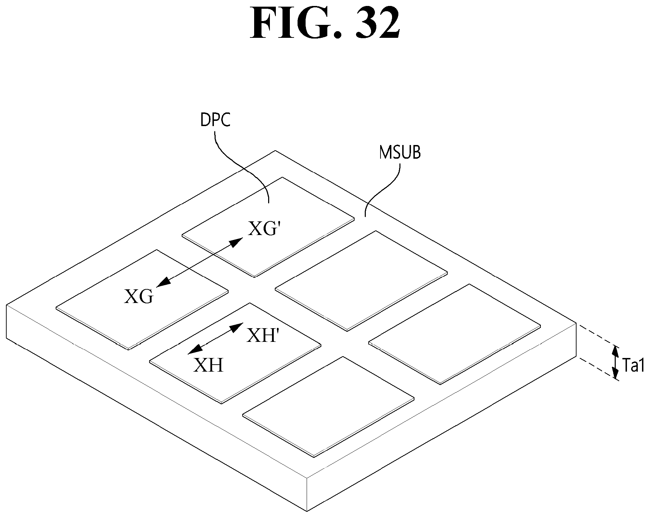

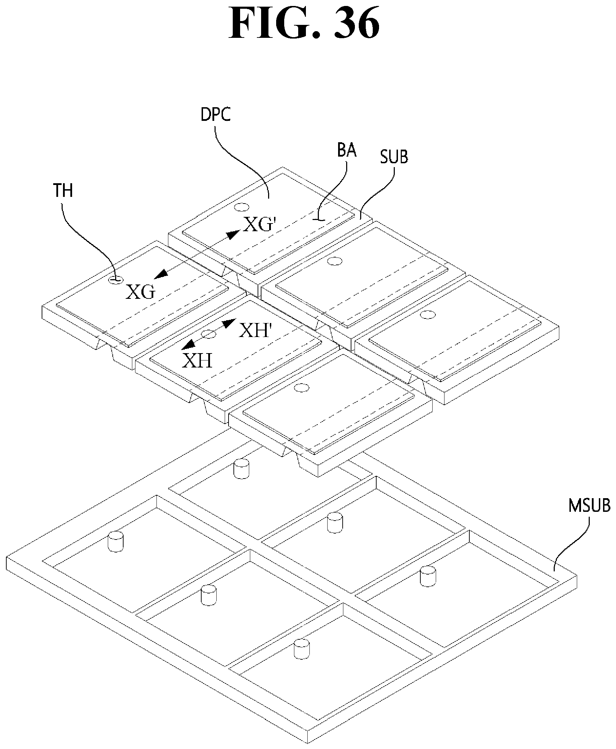

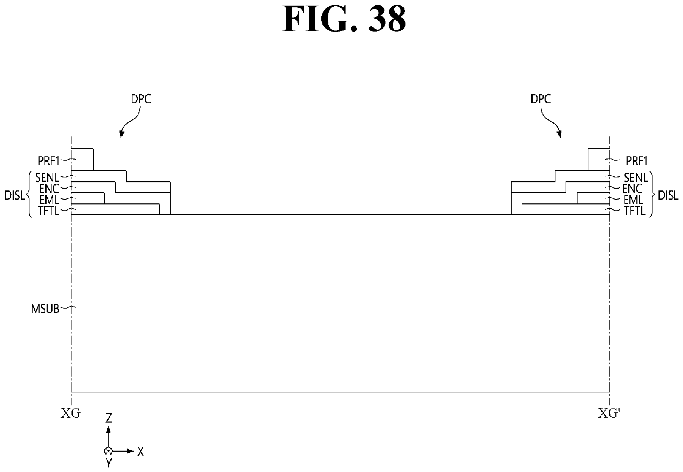

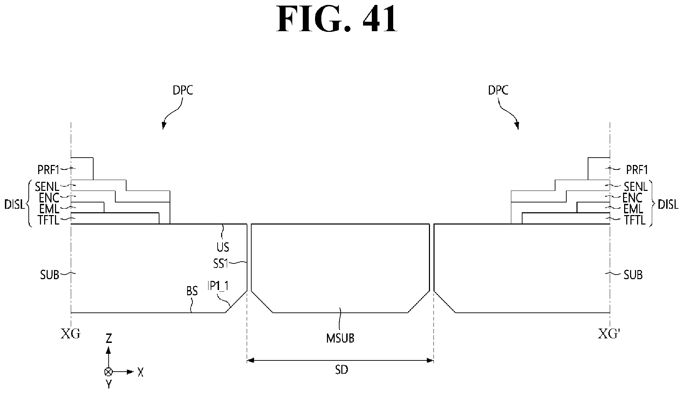

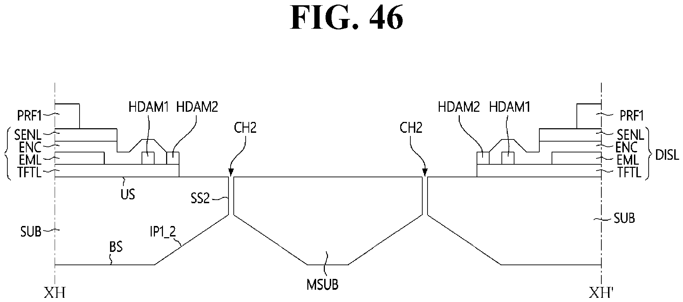

FIG. 30 is a flowchart describing a method of manufacturing a display device by using a laser processing apparatus according to an embodiment. FIG. 31 illustrates depths of laser irradiation areas formed by the laser processing apparatus according to an embodiment. FIGS. 32 through 37 are perspective views illustrating steps of the method of manufacturing the display device by using the laser processing apparatus according to an embodiment. FIGS. 38 through 47 are cross-sectional views illustrating steps of the method of manufacturing the display device by using the laser processing apparatus according to an embodiment.

In the method S1 of manufacturing the display device by using the laser processing apparatus according to an embodiment, first, a plurality of display cells DPC are formed on a first surface of a mother substrate MSUB as illustrated in FIGS. 32, 38, and 43 (operation S110 in FIG. 30).

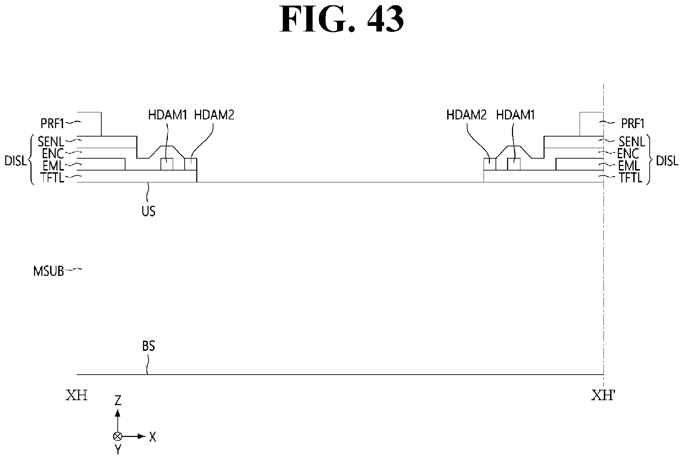

Second, as illustrated in FIGS. 38 and 43, a plurality of first protective films PRF1 are attached onto the display cells DPC, and the display cells DPC are tested (operation S120 in FIG. 30).

First, a first protective film layer is attached to cover the display cells DPC and the mother substrate MSUB disposed between the display cells DPC. Then, the first protective film layer disposed on the mother substrate MSUB is partially removed to form the first protective films PRF1 on the display cells DPC, respectively. For example, portions remaining after the first protective film layer is partially removed may be the first protective films PRF1. Therefore, the first protective films PRF1 may be disposed on the display cells DPC, respectively. That is, the first protective films PRF1 may be disposed to correspond one-to-one to the display cells DPC.

The first protective films PRF1 may be buffer films for respectively protecting the display cells DPC from external impact. The first protective films PRF1 may be made of a transparent material.

Next, the display cells DPC are tested by using a test device. After a probe is connected to a plurality of test pads provided in the display cells DPC, respectively, a lighting test of each of the display cells DPC may be performed.

If the lighting test is performed after the display cells DPC are separated from the mother substrate MSUB by a cutting process, an additional process for removing the test pads is necessary after the completion of the lighting test. However, when the lighting test is performed in a state where the display cells DPC are disposed on the mother substrate MSUB, the test pads are removed later when the display cells DPC are separated from the mother substrate MSUB through laser irradiation and etching. Therefore, when the lighting test is performed in a state where the display cells DPC are disposed on the mother substrate MSUB, an additional process for removing the test pads may be omitted or avoided.

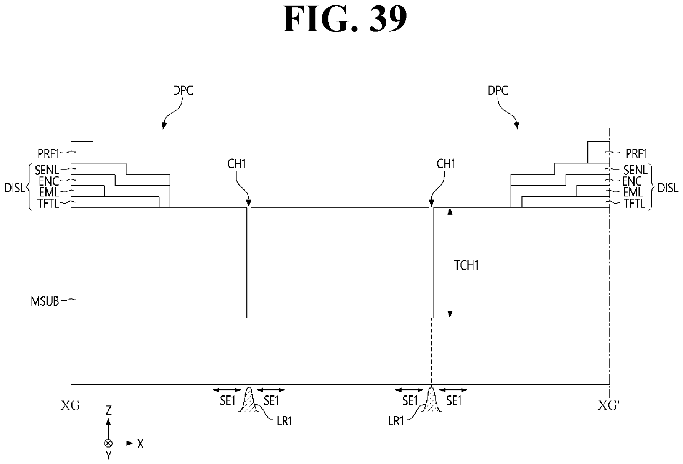

Third, as illustrated in FIGS. 33 and 39, a first laser beam LR1 is irradiated onto a second surface of the mother substrate MSUB, which faces the first surface, to form a plurality of first laser irradiation areas CH1 along edges of each display cell DPC and edges of each bending area BA (operation S130 in FIG. 30).

The first laser beam LR1, according to an embodiment, may use the final Bessel beam FBSB generated by the laser processing apparatus 1, described above with reference to FIG. 1, etc. In the present invention, an embodiment in which the first laser beam LR1 is an infrared Bessel beam having a wavelength of about 1030 nm is described as an example.

As illustrated in FIGS. 33 and 39, the first laser beam LR1 may be irradiated onto the second surface of the mother substrate MSUB. However, embodiments of the present invention are not limited thereto. The first laser beam LR1 may also be irradiated onto the first surface of the mother substrate MSUB.

A first cutting line CL1 may be defined as a virtual line connecting the first laser irradiation areas CH1. The first cutting line CL1 may be formed by forming the first laser irradiation areas CH1 along the edges of each display cell DPC and the edges of each bending area BA by irradiating the first laser beam LR1.

A unilateral tolerance SE1 of the first laser beam LR1 may be equal to or less than 50 μm, and a bilateral tolerance of the first laser beam LR1 may be equal to or less than 100 μm. The unilateral tolerance SE1 of the first laser beam LR1 may be a cutting error in one direction (e.g., X-axis direction) when the first laser irradiation areas CH1 are formed by using the first laser beam LR1.

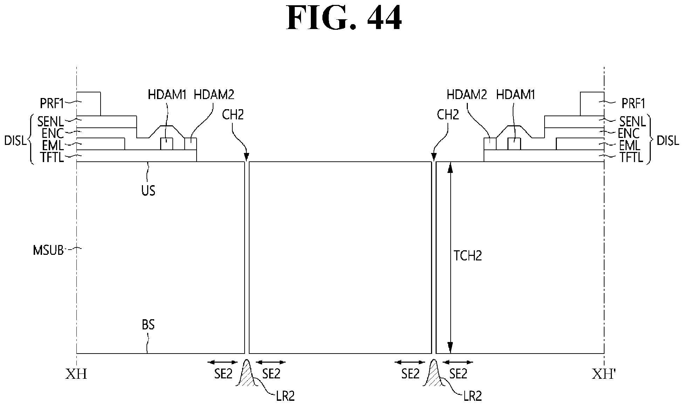

Fourth, as illustrated in FIGS. 34 and 44, a plurality of second laser irradiation areas CH2 for forming a through hole TH in each of the display cells DPC are formed by irradiating a second laser beam LR2 onto the second surface of the mother substrate MSUB (operation S140 in FIG. 30).

Although operation S140 is performed after operation S130 in FIG. 30, embodiments of the present invention are not limited thereto. To reduce the process time, operations S130 and S140 may also be performed concurrently (or simultaneously) by using a plurality of laser processing apparatuses 1, described above.

The second laser beam LR2, according to an embodiment, may use the final Bessel beam FBSB generated by the laser processing apparatus 1 described above with reference to FIG. 1, etc. In the present invention, an embodiment in which the second laser beam LR2 is an infrared Bessel beam having a wavelength of about 1030 nm is described as an example.

As illustrated in FIGS. 34 and 44, the second laser beam LR2 may be irradiated onto the second surface of the mother substrate MSUB. However, embodiments of the present invention are not limited thereto. In other embodiments, the second laser LR2 may be irradiated onto the first surface of the mother substrate MSUB.

A second cutting line CL2 may be defined as a virtual line connecting the second laser irradiation areas CH2. The second cutting line CL2 may be formed by forming the second laser irradiation areas CH2 along edges of the through hole TH by irradiating the second laser beam LR2. The second cutting line CL2 may depend on the shape of the through hole TH. For example, when the through hole TH has a circular planar shape, the second cutting line CL2 may be formed in a circular shape.

A unilateral tolerance SE2 of the second laser beam LR2 may be equal to or less than 50 $\mu$m, and a bilateral tolerance of the second laser beam LR2 may be equal to or less than 100 $\mu$m. The unilateral tolerance SE2 of the second laser beam LR2 may be a cutting error in one direction (e.g., X-axis direction) when the second laser irradiation areas CH2 are formed by using the second laser beam LR2.

When the first laser beam LR1 and the second laser beam LR2 are irradiated onto the second surface of the mother substrate MSUB, a depth (e.g., a sketch length) TCH1 of each of the first laser irradiation areas CH1 and a depth (e.g., a sketch length) TCH2 of each of the second laser irradiation areas CH2 may be adjusted according to repetition rate, processing speed, and pulse energy.

For example, the depth TCH1 of each of the first laser irradiation areas CH1 may be about 50 $\mu$m from the first surface of the mother substrate MSUB as illustrated in FIG. 31a. In addition, because a thickness of the mother substrate MSUB is about 500 $\mu$m, the depth TCH2 of each of the second laser irradiation areas CH2 may be maximum of about 500 $\mu$m as illustrated in FIG. 31b. For example, the depth TCH1 of each of the first laser irradiation areas CH1 may be in a range of about 50 $\mu$m to about 500 $\mu$m from the first surface of the mother substrate MSUB.

The first laser beam LR1 for forming the first laser irradiation areas CH1 may be irradiated with a repetition rate in a range of about 10 kHz to about 250 kHz, a processing speed in a range of about 10 mm/s to about 250 mm/s, and a pulse energy in a range of 10 uJ to about 300 uJ. However, for the first laser beam LR1 to have (or to form) a depth of about 225 $\mu$m from the first surface of the mother substrate MSUB, the first laser beam LR1 may be irradiated with a repetition rate in a range of about 17.5 kHz to about 125 kHz, a processing speed in a range of about 17.5 mm/s to about 125 mm/s, and a pulse energy in a range of about 25 uJ to about 178 uJ.

The second laser beam LR2 for forming the second laser irradiation areas CH2 may be irradiated with a repetition rate in a range of about 1 kHz to about 50 kHz, a processing speed in a range of about 1 mm/s to about 50 mm/s, and a pulse energy in a range of about 10 uJ to about 300 uJ. However, for the second laser beam LR2 to have (or to form) a depth in a range of about 400 $\mu$m to about 500 $\mu$m from the first surface of the mother substrate MSUB, the second laser beam LR2 may be irradiated with a repetition rate of about 10 kHz, a processing speed of about 10 mm/s, and a pulse in a range of about 60 uJ to about 178 uJ. For example, while the second laser beam LR2 forms the circular second cutting line CL2, the first laser beam LR1 forms the first cutting line CL1 along the edges of each of the display cells DPC. Therefore, the processing speed of the second laser beam LR2 may be lower than that of the first laser beam LR1.

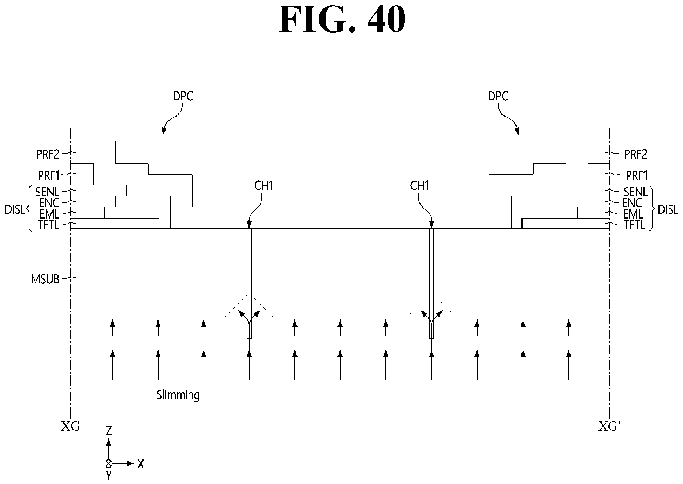

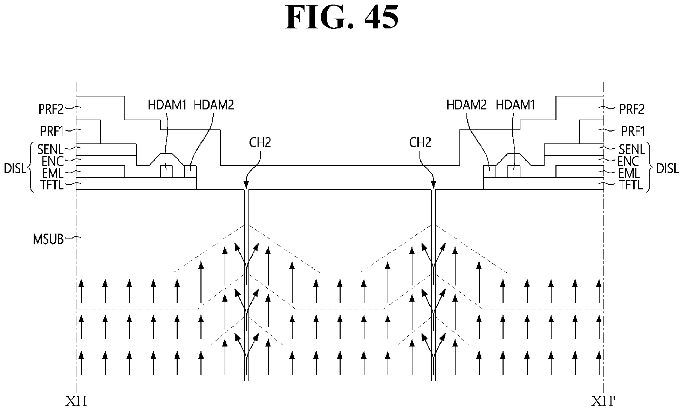

Fifth, as illustrated in FIGS. 40 and 45, a second protective film PRF2 is attached onto the first protective films PRF1 (operation S150 in FIG. 30).

The second protective film PRF2 may be attached onto the first protective films PRF1 and the mother substrate MSUB exposed without being covered by the first protective films PRF1. The second protective film PRF2 may cover the first laser irradiation areas CH1 and the second laser irradiation areas CH2. The second protective film PRF2 may be an acid-resistant film for protecting the display cells DPC from an etchant in an etching process of the mother substrate MSUB, which will be performed in a subsequent (or next) operation.

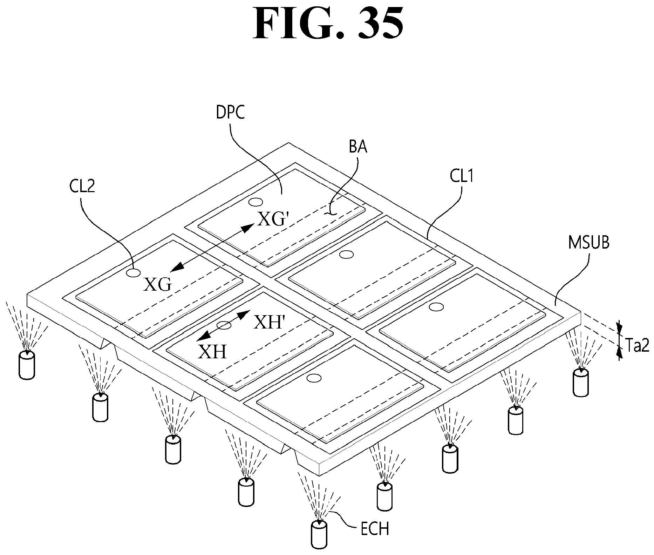

Sixth, as illustrated in FIGS. 35, 36, 40, 41, 42, 45, 46, and 47, an etchant is sprayed onto the second surface of the mother substrate MSUB without using a mask to reduce the thickness of the mother substrate MSUB while cutting the mother substrate MSUB along the first laser irradiation areas CH1 and the second laser irradiation areas CH2, and the second protective film PRF2 is detached (operation S160 in FIG. 30).

When the etchant is sprayed onto the second surface of the mother substrate MSUB, the mother substrate MSUB may be reduced from a first thickness Ta1 to a second thickness Ta2. Because the mother substrate MSUB is etched without using a mask, it may be isotropically etched, that is, the entire second surface of the mother substrate MSUB may be uniformly etched.

Each of the first laser irradiation areas CH1 may include a physical hole formed by the first laser beam LR1 and an area around the physical hole where physical properties of the mother substrate MSUB are changed by the first laser beam LR1. In other embodiments, however, each of the first laser irradiation areas CH1 may not include a physical hole and may be an area whose physical properties are changed by the first laser beam LR1. Therefore, an etch rate in each of the first laser irradiation areas CH1 by an etchant may be higher than an etch rate in other areas of the mother substrate MSUB to which the first laser beam LR1 is not irradiated.

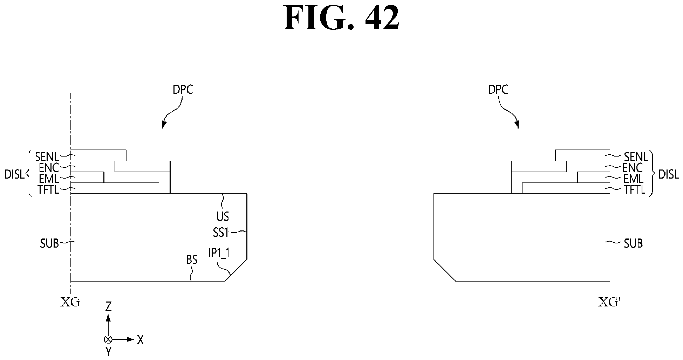

When the etchant reduces the thickness of the mother substrate MSUB and then penetrates into the first laser irradiation areas CH1 formed by the first laser beam LR1, there may be a difference in etching speed between an area where the first laser irradiation areas CH1 are formed and an area where the first laser irradiation areas CH1 are not formed. That is, the mother substrate MSUB may be anisotropically etched, that is, an etch rate in the area where the first laser irradiation areas CH1 are formed may be higher than an etch rate in the area where the first laser irradiation areas CH1 are not formed. Accordingly, as illustrated in FIG. 42, a substrate SUB separated from the mother substrate MSUB may have a first inclined surface IP1_1 disposed between a side surface SS1 and a lower surface BS.

In addition, as the etchant penetrates into the first laser irradiation areas CH1 formed by the first laser beam LR1, the mother substrate MUSB may be cut along the first cutting line CL1. That is, each of the display cells DPC may be separated from the mother substrate MSUB.

While the first surface of the substrate SUB separated from the mother substrate MSUB is protected from penetration of the etchant by the second protective film PRF2, the second surface of the substrate SUB is etched by the etchant. Therefore, the first surface and the second surface of the substrate SUB may be different in roughness, hardness, light transmittance, light reflectance, local density, surface chemical structure, and the like. For example, dimples may be generated on the second surface of the substrate SUB due to the etchant. The dimples refer to fine defects, such as scratches, existing on the second surface of the substrate SUB, which have enlarged by reacting with the etchant.

The unilateral tolerance of the first laser beam LR1 may be about 50 $\mu$m, and a width of each of the first laser irradiation areas CH1 formed by the first laser beam LR1 may be increased by about 40 $\mu$m due to the etchant. Therefore, considering the bilateral tolerance of the first laser beam LR1 irradiated to each of the display cells DPC and the width of each of the first laser irradiation areas CH1 increased by the etchant, a separation distance SD between neighboring display cells DPC may be about 280 $\mu$m.

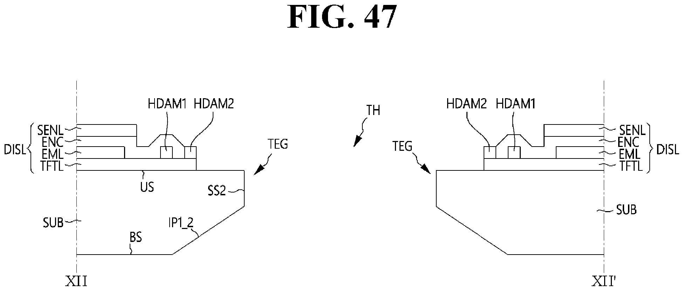

Each of the second laser irradiation areas CH2 may include a physical hole formed by the second laser beam LR2 and an area around the physical hole where physical properties of the mother substrate MSUB are changed by the second laser beam LR2. In other embodiments, however, each of the second laser irradiation areas CH2 may not include a physical hole and may be an area whose physical properties are changed by the second laser beam LR2. Therefore, an etch rate in each of the second laser irradiation areas CH2 by the etchant may be higher than an etch rate in other areas of the mother substrate MSUB to which the second laser beam LR2 is not irradiated. Therefore, as illustrated in FIG. 47, the substrate SUB separated from the mother substrate MSUB may include a second inclined surface IP1_2 disposed between a side surface SS2 and the lower surface BS at an edge TEG of the through hole TH.

In addition, as the etchant penetrates into the second laser irradiation areas CH2 formed by the second laser beam LR2, the mother substrate MUSB may be cut along the second cutting line CL2 to form the through hole TH.

Here, as illustrated in FIGS. 40 and 45, because the depth of each of the second laser irradiation areas CH2 is greater than the depth of each of the first laser irradiation areas CH1, the etchant may penetrate into the second laser irradiation areas CH2 earlier than into the first laser irradiation areas CH1. That is, because the second laser irradiation areas CH2 are etched along with a slimming process in which the thickness of the mother substrate MSUB is reduced by the etchant, the substrate SUB forms a tapered cross-section due to isotropic etching in the through hole TH formed by the second laser irradiation areas CH2. On the other hand, the first laser irradiation areas CH1 are not etched during the slimming process. Therefore, the length and angle of the first inclined surface IP1_1 in an inclination direction at an edge of the substrate SUB formed by the first laser irradiation areas CH1 are different from the length and angle of the second inclined surface IP1_2 in the inclination direction in the through hole TH formed by the second laser irradiation areas CH2.

After the etching process is completed, the second protective film PRF2 may be detached.

Through the etching process, each of the display cells DPC may be separated from the mother substrate MSUB, the through hole TH may be formed in each of the display cells DPC, and the mother substrate MSUB of each bending area BA may be removed.

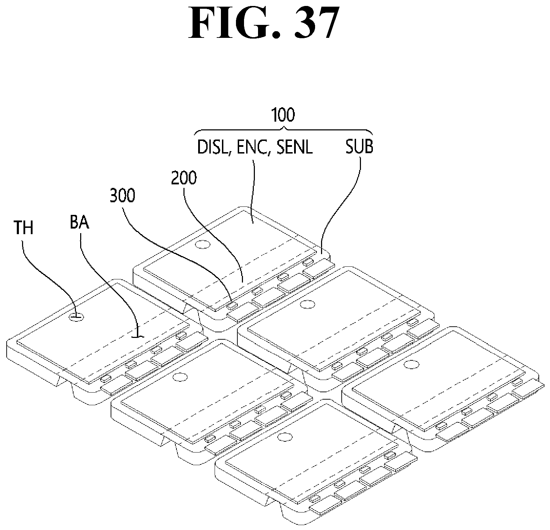

Seventh, as illustrated in FIGS. 37, 42, and 47, driving ICs 200 and circuit boards 300 are attached to each of the display cells DPC, and the first protective films PRF1 are detached from the display cells DPC, respectively (operation S170 in FIG. 30).

As described above, the laser and etching processes do not only reduce the thickness of the substrate SUB and separate the substrate SUB of each of the display cells DPC from the mother substrate MSUB but also form the through hole TH and remove the substrate SUB of each bending area BA. Therefore, the efficiency of the manufacturing process can be increased.

In concluding the detailed description, those skilled in the art will appreciate that many variations and modifications can be made to the embodiments described herein without substantially departing from the present invention.

Therefore, the described embodiments of the present invention are to be understood in a generic and descriptive sense and not for purposes of limitation.

**Claims**

1. An apparatus for manufacturing a display device, the apparatus comprising:

   a light source (LSR) for generating a first beam (GSB);
   a beam converter (RGU) comprising an axicon lens (AXC) for converting the first beam (GSB) into a second beam (RBSB) and a relay lens (RLL) for converting the second beam (RBSB) into a third beam (RSB);
   a scanner (SCN) comprising a first mirror (MRR1) for reflecting the third beam (RSB) in a first direction (DR1) and a second mirror (MRR2) for reflecting the third beam (RSB) in a second direction (DR2) different from the first direction (DR1); and
   a scan lens (SCL) having an effective focal length (fG) and being for converting the third beam (RSB) output from the scanner (SCN) into a fourth beam (FBSB), the scan lens (SCL) comprising a first lens (L1) having a first focal length (f1), a second lens (L2) having a second focal length (f2), a third lens (L3) having a third focal length (f3), a fourth lens (L4) having a fourth focal length (f4), a fifth lens (L5) having a fifth focal length (f5), and a cover window (CG),
   wherein an absolute value of the first focal length (f1) is smaller than an absolute value of each of the second through fifth focal lengths (f2, f3).

2. The apparatus of claim 1, wherein the first through fifth lenses (L1 to L5) and the cover window (CG) are sequentially arranged.

3. The apparatus of claim 1 or 2, wherein the first beam (GSB) is a Gaussian beam, the second beam (RBSB) is a raw Bessel beam, the third beam (RSB) is a ring-shaped beam, and the fourth beam (FBSB) is a final Bessel beam.

4. The apparatus of at least one of claims 1 to 3,
   wherein the first through fifth focal lengths (f1 to f5) and the effective focal length (fG) satisfy Equation 1:

$$-1.4 < f1/fG < -1.0,\ +3.0 < f2/fG < +3.4,\ +3.1 < f3/fG < +3.3,\ +3.3 < f4/fG < +3.7,\ +3.5 < f5/fG < +3.9.$$

5. The apparatus of at least one of claims 1 to 4, wherein the first mirror (MRR1) is configured to deflect the third beam (RSB) in the first direction (DR1) by a first angle, and
   wherein the second mirror (MRR2) is configured to deflect the third beam (RSB) in the second direction (DR2) by a second angle.

6. The apparatus of claim 5, wherein the first angle is $\beta x$,

   wherein the second angle is $\beta y$,
   wherein a distance between the first mirror (MRR1) and the second mirror (MRR2) is M1,
   wherein a distance between the second mirror (MRR2) and the scan lens (SCL) is M2,
   wherein a distance by which the third beam (RSB), before being incident on the scan lens (SCL), is deflected in the first direction (DR1) is a first movement distance $\Delta x$,
   wherein a distance by which the third beam (RSB), before being incident on the scan lens (SCL), is deflected in the second direction (DR2) is a second movement distance $\Delta y$, and
   wherein the first movement distance $\Delta x$ and the second movement distance $\Delta y$ satisfy Equation 2:

$$\Delta x = (M1+M2)*\beta x,\ \Delta y = M2*\beta y.$$

7. The apparatus of at least one of claims 1 to 6, wherein the third beam (RSB) is a ring-shaped beam having a diameter of 2W0, and
   wherein a size CA of a clear aperture of the scan lens (SCL) satisfies Equation 3:

$$CA > \max(\Delta y,\ \Delta x) + 2W0.$$

28

8. The apparatus of at least one of claims 1 to 7, wherein half of a length of a scanning field in the first direction (DR1) formed on a focal plane (FP) by the fourth beam (FBSB) is dx,

wherein half of a length of the scanning field in the second direction (DR2) formed on a focal plane (FP) by the fourth beam (FBSB) is dy,
wherein dx is equal to a value obtained by multiplying the first angle by the effective focal length (fG), and
wherein dy is equal to a value obtained by multiplying the second angle by the effective focal length (fG).

9. The apparatus of at least one of claims 1 to 8, wherein an effective length of the second beam (RBSB) is longer than an effective length of the fourth beam (FBSB).

10. The apparatus of at least one of claims 1 to 9, wherein a distance between the relay lens (RLL) and the axicon lens (AXC) is equal to a distance between the relay lens (RLL) and an entrance pupil of the scanner (SCN).

11. The apparatus of claim 10, wherein the distance between the relay lens (RLL) and the axicon lens (AXC) and the distance between the relay lens (RLL) and the entrance pupil of the scanner (SCN) are equal to a sixth focal length, the sixth focal length being a focal length of the relay lens (RLL).

12. The apparatus of at least one of claims 1 to 11, wherein the first lens (L1) is a double concave lens,

wherein the second lens (L2) and the fifth lens (L5) are meniscus lenses, and
wherein the third lens (L3) and the fourth lens (L4) are double convex lenses.

13. The apparatus of claim 12, wherein the second lens (L2) has a concave incident surface and a convex exit surface, and wherein the fifth lens (L5) has a convex incident surface and a concave exit surface.

14. The apparatus of at least one of claims 1 to 13, wherein a distance between an entrance pupil of the scanner (SCN) and the first lens (L1) is greater than a distance between the first lens (L1) and the second lens (L2).

15. The apparatus of at least one of claims 10 to 14, wherein the distance between the entrance pupil of the scanner (SCN) and the first lens (L1) is in a range of 15 mm to 50 mm.

16. The apparatus of at least one of claims 1 to 14, wherein the distance between the first lens (L1) and the second lens (L2) is greater than a distance between the second lens (L2) and the third lens (L3).

17. The apparatus of at least one of claims 1 to 16, wherein the distance between the second lens (L2) and the third lens (L3) is equal to a distance between the third lens (L3) and the fourth lens (L4) and a distance between the fourth lens (L4) and the fifth lens (L5).

18. The apparatus of at least one of claims 1 to 17, wherein a retroreflection point to which the third beam (RSB) is retroreflected by the cover window (CG) is not located on the first through fifth lenses (L1 to L5).

19. The apparatus of claim 18, wherein the retroreflection point is located between the first lens (L1) and the second lens (L2).

20. A display device manufactured by using the apparatus of at least one of claims 1 to 19, the display device comprising:

a glass substrate (SUB) having a first surface, a second surface facing the first surface, a side surface connected to the first surface, and a first inclined surface (IP1_1) extending between the side surface and the second surface; and
a display area (DA) having a plurality of emission areas (EA) on the first surface of the glass substrate (SUB), wherein the side surface and the first inclined surface (IP1_1) are formed by irradiating a laser beam to form first laser irradiation areas (CH1) and then separating the glass substrate (SUB) from a mother substrate (MSUB) along the first laser irradiation areas (CH1) through an etching process, and
wherein the laser beam is the fourth beam (FBSB) of the apparatus for manufacturing the display device of at least one of claims 1 to 19.

**Patentansprüche**

1. Vorrichtung zum Herstellen einer Anzeigeeinrichtung, wobei die Vorrichtung Folgendes umfasst:

   eine Lichtquelle (LSR) zum Erzeugen eines ersten Strahls (GSB);
   einen Strahlenwandler (RGU), umfassend eine Axikonlinse (AXC) zum Umwandeln des ersten Strahls (GSB) in einen zweiten Strahl (RBSB) und eine Relaislinse (RLL) zum Umwandeln des zweiten Strahls (RBSB) in einen dritten Strahl (RSB);
   einen Scanner (SCN), umfassend einen ersten Spiegel (MRR1) zum Reflektieren des dritten Strahls (RSB) in eine erste Richtung (DR1) und einen zweiten Spiegel (MRR2) zum Reflektieren des dritten Strahls (RSB) in eine zweite Richtung (DR2), die sich von der ersten Richtung (DR1) unterscheidet; und
   eine Scanlinse (SCL) mit einer effektiven Brennweite (fG) und zum Umwandeln des dritten Strahls (RSB), der von dem Scanner (SCN) ausgegeben wird, in einen vierten Strahl (FBSB), wobei die Scanlinse (SCL) eine erste Linse (L1) mit einer ersten Brennweite (f1), eine zweite Linse (L2) mit einer zweiten Brennweite (f2), eine dritte Linse (L3) mit einer dritten Brennweite (f3), eine vierte Linse (L4) mit einer vierten Brennweite (f4), eine fünfte Linse (L5) mit einer fünften Brennweite (f5) und ein Abdeckfenster (CG) umfasst,
   wobei ein absoluter Wert der ersten Brennweite (f1) kleiner als ein absoluter Wert jeder von der zweiten bis zur fünften Brennweite (f2, f3) ist.

2. Vorrichtung nach Anspruch 1, wobei die erste bis fünfte Linse (L1 bis L5) und das Abdeckfenster (CG) aufeinanderfolgend angeordnet sind.

3. Vorrichtung nach Anspruch 1 oder 2, wobei der erste Strahl (GSB) ein Gauß-Strahl ist, der zweite Strahl (RBSB) ein roher Bessel-Strahl ist, der dritte Strahl (RSB) ein ringförmiger Strahl ist und der vierte Strahl (FBSB) ein finaler Bessel-Strahl ist.

4. Vorrichtung nach mindestens einem der Ansprüche 1 bis 3,
   wobei die erste bis fünfte Brennweite (f1 bis f5) und die effektive Brennweite (fG) Gleichung 1 erfüllen:

   $-1,4 < f1/fG < -1,0$, $+3,0 < f2/fG < +3,4$, $+3,1 < f3/fG < +3,3$, $+3,3 < f4/fG < +3,7$, $+3,5 < f5/fG < +3,9$.

5. Vorrichtung nach mindestens einem der Ansprüche 1 bis 4, wobei der erste Spiegel (MRR1) dazu konfiguriert ist, den dritten Strahl (RSB) in die erste Richtung (DR1) um einen ersten Winkel abzulenken, und
   wobei der zweite Spiegel (MRR2) dazu konfiguriert ist, den dritten Strahl (RSB) in der zweiten Richtung (DR2) um einen zweiten Winkel abzulenken.

6. Vorrichtung nach Anspruch 5, wobei der erste Winkel $\beta x$ ist,

   wobei der zweite Winkel ßy ist,
   wobei ein Abstand zwischen dem ersten Spiegel (MRR1) und dem zweiten Spiegel (MRR2) M1 ist,
   wobei ein Abstand zwischen dem zweiten Spiegel (MRR2) und der Scanlinse (SCL) M2 ist,
   wobei ein Abstand, um den der dritte Strahl (RSB), bevor er auf die Scanlinse (SCL) einfällt, in die erste Richtung (DR1) abgelenkt wird, ein erster Bewegungsabstand $\Delta x$ ist,
   wobei ein Abstand, um den der dritte Strahl (RSB), bevor er auf die Scanlinse (SCL) einfällt, in die zweite Richtung (DR2) abgelenkt wird, ein zweiter Bewegungsabstand $\Delta y$ ist, und
   wobei der erste Bewegungsabstand $\Delta x$ und der zweite Bewegungsabstand $\Delta y$ Gleichung 2 erfüllen:

   $$\Delta x = (M1+M2)^* ßx, \quad \Delta y = M2^* ßy.$$

7. Vorrichtung nach mindestens einem der Ansprüche 1 bis 6, wobei der dritte Strahl (RSB) ein ringförmiger Strahl mit einem Durchmesser von 2W0 ist, und
   wobei eine Größe CA einer durchsichtigen Öffnung der Scanlinse (SCL) Gleichung 3 erfüllt:

   $$CA > \max(\Delta y, \Delta x) + 2W0.$$

8. Vorrichtung nach mindestens einem der Ansprüche 1 bis 7, wobei die Hälfte einer Länge eines Scanfelds in der ersten Richtung (DR1), das auf einer Brennebene (FP) durch den vierten Strahl (FBSB) gebildet wird, dx ist,

wobei die Hälfte einer Länge des Scanfelds in der zweiten Richtung (DR2), das auf einer Brennebene (FP) durch den vierten Strahl (FBSB) gebildet wird, dy ist,
wobei dx gleich einem Wert ist, der durch Multiplizieren des ersten Winkels mit der effektiven Brennweite (fG) erhalten wird, und
wobei dy gleich einem Wert ist, der durch Multiplizieren des zweiten Winkels mit der effektiven Brennweite (fG) erhalten wird.

9. Vorrichtung nach mindestens einem der Ansprüche 1 bis 8, wobei eine effektive Länge des zweiten Strahls (RBSB) länger als eine effektive Länge des vierten Strahls (FBSB) ist.

10. Vorrichtung nach mindestens einem der Ansprüche 1 bis 9, wobei ein Abstand zwischen der Relaislinse (RLL) und der Axikonlinse (AXC) gleich einem Abstand zwischen der Relaislinse (RLL) und einer Eintrittspupille des Scanners (SCN) ist.

11. Vorrichtung nach Anspruch 10, wobei der Abstand zwischen der Relaislinse (RLL) und der Axikonlinse (AXC) und der Abstand zwischen der Relaislinse (RLL) und der Eintrittspupille des Scanners (SCN) gleich einer sechsten Brennweite sind, wobei die sechste Brennweite eine Brennweite der Relaislinse (RLL) ist.

12. Vorrichtung nach mindestens einem der Ansprüche 1 bis 11, wobei die erste Linse (L1) eine doppelte konkave Linse ist,

wobei die zweite Linse (L2) und die fünfte Linse (L5) Meniskuslinsen sind, und
wobei die dritte Linse (L3) und die vierte Linse (L4) doppelte konvexe Linsen sind.

13. Vorrichtung nach Anspruch 12, wobei die zweite Linse (L2) eine konkave Einfallsfläche und eine konvexe Austrittsfläche aufweist, und
wobei die fünfte Linse (L5) eine konvexe Einfallsfläche und eine konkave Austrittsfläche aufweist.

14. Vorrichtung nach mindestens einem der Ansprüche 1 bis 13, wobei ein Abstand zwischen einer Eintrittspupille des Scanners (SCN) und der ersten Linse (L1) größer ist als ein Abstand zwischen der ersten Linse (L1) und der zweiten Linse (L2).

15. Vorrichtung nach mindestens einem der Ansprüche 10 bis 14, wobei der Abstand zwischen der Eintrittspupille des Scanners (SCN) und der ersten Linse (L1) in einem Bereich von 15 mm bis 50 mm liegt.

16. Vorrichtung nach mindestens einem der Ansprüche 1 bis 14, wobei der Abstand zwischen der ersten Linse (L1) und der zweiten Linse (L2) größer ist als ein Abstand zwischen der zweiten Linse (L2) und der dritten Linse (L3).

17. Vorrichtung nach mindestens einem der Ansprüche 1 bis 16, wobei der Abstand zwischen der zweiten Linse (L2) und der dritten Linse (L3) gleich einem Abstand zwischen der dritten Linse (L3) und der vierten Linse (L4) und einem Abstand zwischen der vierten Linse (L4) und der fünften Linse (L5) ist.

18. Vorrichtung nach mindestens einem der Ansprüche 1 bis 17, wobei sich ein Retroreflexionspunkt, zu dem der dritte Strahl (RSB) durch das Abdeckfenster (CG) retroreflektiert wird, nicht auf der ersten bis fünften Linse (L1 bis L5) befindet.

19. Vorrichtung nach Anspruch 18, wobei sich der Retroreflexionspunkt zwischen der ersten Linse (L1) und der zweiten Linse (L2) befindet.

20. Anzeigeeinrichtung, hergestellt unter Verwendung der Vorrichtung nach mindestens einem der Ansprüche 1 bis 19, wobei die Anzeigeeinrichtung Folgendes umfasst:

ein Glassubstrat (SUB), das eine erste Fläche, eine zweite Fläche, die der ersten Fläche zugewandt ist, eine Seitenfläche, die mit der ersten Fläche verbunden ist, und eine erste geneigte Fläche (IP1_1), die sich zwischen der Seitenfläche und der zweiten Fläche erstreckt, aufweist; und

einen Anzeigebereich (DA), der eine Vielzahl von Emissionsbereichen (EA) auf der ersten Fläche des Glassubstrats (SUB) aufweist,

wobei die Seitenfläche und die erste geneigte Fläche (IP1_1) durch Bestrahlen mit einem Laserstrahl, um erste Laserbestrahlungsbereiche (CH1) zu bilden, und anschließendes Ablösen des Glassubstrats (SUB) von einem Muttersubstrat (MSUB) entlang der ersten Laserbestrahlungsbereiche (CH1) durch einen Ätzprozess gebildet werden und

wobei der Laserstrahl der vierte Strahl (FBSB) der Vorrichtung zum Herstellen der Anzeigeeinrichtung nach mindestens einem der Ansprüche 1 bis 19 ist.

**Revendications**

1. Appareil pour la fabrication d'un dispositif d'affichage, l'appareil comprenant :

   une source de lumière (LSR) pour générer un premier faisceau (GSB) ;
   un convertisseur de faisceau (RGU) comprenant une lentille axicon (AXC) pour convertir le premier faisceau (GSB) en un deuxième faisceau (RBSB) et une lentille relais (RLL) pour convertir le deuxième faisceau (RBSB) en un troisième faisceau (RSB) ;
   un dispositif de balayage (SCN) comprenant un premier miroir (MRR1) pour réfléchir le troisième faisceau (RSB) dans une première direction (DR1) et un deuxième miroir (MRR2) pour réfléchir le troisième faisceau (RSB) dans une deuxième direction (DR2) différente de la première direction (DR1) ; et
   une lentille de balayage (SCL) ayant une longueur focale effective (fG) et destinée à convertir le troisième faisceau (RSB) délivré par le dispositif de balayage (SCN) en un quatrième faisceau (FBSB), la lentille de balayage (SCL) comprenant une première lentille (L1) ayant une première longueur focale (f1), une deuxième lentille (L2) ayant une deuxième longueur focale (f2), une troisième lentille (L3) ayant une troisième longueur focale (f3), une quatrième lentille (L4) ayant une quatrième longueur focale (f4), une cinquième lentille (L5) ayant une cinquième longueur focale (f5), et une fenêtre de couverture (CG),
   dans lequel une valeur absolue de la première longueur focale (f1) est plus petite qu'une valeur absolue de chacune des deuxième à cinquième longueurs focales (f2, f3).

2. Appareil selon la revendication 1, dans lequel les première à cinquième lentilles (L1 à L5) et la fenêtre de couverture (CG) sont agencées séquentiellement.

3. Appareil selon la revendication 1 ou 2, dans lequel le premier faisceau (GSB) est un faisceau gaussien, le deuxième faisceau (RBSB) est un faisceau de Bessel brut, le troisième faisceau (RSB) est un faisceau en forme d'anneau et le quatrième faisceau (FBSB) est un faisceau de Bessel final.

4. Appareil selon au moins l'une des revendications 1 à 3,
   dans lequel les première à cinquième longueurs focales (f1 à f5) et la longueur focale effective (fG) satisfont l'équation 1 :

   $-1,4 < f1/fG < -1,0, +3,0 < f2/fG < +3,4, +3,1 < f3/fG < +3,3, +3,3 < f4/fG < +3,7, +3,5 < f5/fG < +3,9$.

5. Appareil selon au moins l'une des revendications 1 à 4, dans lequel le premier miroir (MRR1) est configuré pour dévier le troisième faisceau (RSB) dans la première direction (DR1) d'un premier angle, et
   dans lequel le deuxième miroir (MRR2) est configuré pour dévier le troisième faisceau (RSB) dans la deuxième direction (DR2) d'un deuxième angle.

6. Appareil selon la revendication 5, dans lequel le premier angle est $\beta x$,

   dans lequel le deuxième angle est $\beta y$,
   dans lequel une distance entre le premier miroir (MRR1) et le deuxième miroir (MRR2) est M1,
   dans lequel une distance entre le deuxième miroir (MRR2) et la lentille de balayage (SCL) étant M2,
   dans lequel une distance sur laquelle le troisième faisceau (RSB), avant d'être incident sur la lentille de balayage (SCL), est dévié dans la première direction (DR1) est une première distance de déplacement $\Delta x$,
   dans lequel une distance sur laquelle le troisième faisceau (RSB), avant d'être incident sur la lentille de balayage (SCL), est dévié dans la deuxième direction (DR2) est une deuxième distance de déplacement Δy, et
dans lequel la première distance de déplacement Δx et la deuxième distance de déplacement Δy satisfont l'équation 2 :

$$\Delta x = (M1 + M2)^*\beta x, \; \Delta y = M2^*\beta y.$$

7. Appareil selon au moins l'une des revendications 1 à 6, dans lequel le troisième faisceau (RSB) est un faisceau en forme d'anneau ayant un diamètre de 2W0, et dans lequel une taille CA d'une ouverture claire de la lentille de balayage (SCL) satisfait l'équation 3 :

$$CA > max(\Delta y, \Delta x) + 2W0.$$

8. Appareil selon au moins l'une des revendications 1 à 7, dans lequel la moitié d'une longueur d'un champ de balayage dans la première direction (DR1) formé sur un plan focal (FP) par le quatrième faisceau (FBSB) est dx,

dans lequel la moitié d'une longueur du champ de balayage dans la deuxième direction (DR2) formé sur un plan focal (FP) par le quatrième faisceau (FBSB) est dy,
dans lequel dx est égal à une valeur obtenue en multipliant le premier angle par la longueur focale effective (fG), et
dans lequel dy est égal à une valeur obtenue en multipliant le deuxième angle par la longueur focale effective (fG).

9. Appareil selon au moins l'une des revendications 1 à 8, dans lequel une longueur effective du deuxième faisceau (RBSB) est plus longue qu'une longueur effective du quatrième faisceau (FBSB).

10. Appareil selon au moins l'une des revendications 1 à 9, dans lequel une distance entre la lentille relais (RLL) et la lentille axicon (AXC) est égale à une distance entre la lentille relais (RLL) et une pupille d'entrée du dispositif de balayage (SCN).

11. Appareil selon la revendication 10, dans lequel la distance entre la lentille relais (RLL) et la lentille axicon (AXC) et la distance entre la lentille relais (RLL) et la pupille d'entrée du dispositif de balayage (SCN) sont égales à une sixième longueur focale, la sixième longueur focale étant une longueur focale de la lentille relais (RLL).

12. Appareil selon au moins l'une des revendications 1 à 11, dans lequel la première lentille (L1) est une lentille biconcave,

dans lequel la deuxième lentille (L2) et la cinquième lentille (L5) sont des lentilles ménisques, et
dans lequel la troisième lentille (L3) et la quatrième lentille (L4) sont des lentilles biconvexes.

13. Appareil selon la revendication 12, dans lequel la deuxième lentille (L2) a une surface incidente concave et une surface de sortie convexe, et
dans lequel la cinquième lentille (L5) a une surface incidente convexe et une surface de sortie concave.

14. Appareil selon au moins l'une des revendications 1 à 13, dans lequel une distance entre une pupille d'entrée du dispositif de balayage (SCN) et la première lentille (L1) est supérieure à une distance entre la première lentille (L1) et la deuxième lentille (L2).

15. Appareil selon au moins l'une des revendications 10 à 14, dans lequel la distance entre la pupille d'entrée du dispositif de balayage (SCN) et la première lentille (L1) est dans une plage de 15 mm à 50 mm.

16. Appareil selon au moins l'une des revendications 1 à 14, dans lequel la distance entre la première lentille (L1) et la deuxième lentille (L2) est supérieure à une distance entre la deuxième lentille (L2) et la troisième lentille (L3).

17. Appareil selon au moins l'une des revendications 1 à 16, dans lequel la distance entre la deuxième lentille (L2) et la troisième lentille (L3) est égale à une distance entre la troisième lentille (L3) et la quatrième lentille (L4) et à une distance entre la quatrième lentille (L4) et la cinquième lentille (L5).

18. Appareil selon au moins l'une des revendications 1 à 17, dans lequel un point de rétroréflexion vers lequel le troisième faisceau (RSB) est rétroréfléchi par la fenêtre de couverture (CG) n'est pas situé sur les première à cinquième lentilles (L1 à L5).

19. Appareil selon la revendication 18, dans lequel le point de rétroréflexion est situé entre la première lentille (L1) et la deuxième lentille (L2).

20. Dispositif d'affichage fabriqué à l'aide de l'appareil d'au moins l'une des revendications 1 à 19, le dispositif d'affichage comprenant :

un substrat en verre (SUB) ayant une première surface, une deuxième surface faisant face à la première surface, une surface latérale reliée à la première surface, et une première surface inclinée (IP1_1) s'étendant entre la surface latérale et la deuxième surface ; et
une zone d'affichage (DA) ayant une pluralité de zones d'émission (EA) sur la première surface du substrat en verre (SUB),
dans lequel la surface latérale et la première surface inclinée (IP1_1) sont formées en irradiant un faisceau laser pour former des premières zones d'irradiation laser (CH1), puis en séparant le substrat en verre (SUB) d'un substrat mère (MSUB) le long des premières zones d'irradiation laser (CH1) par un processus de gravure, et
dans lequel le faisceau laser est le quatrième faisceau (FBSB) de l'appareil de fabrication du dispositif d'affichage d'au moins l'une des revendications 1 à 19.

# FIG. 1

# FIG. 2

# FIG. 3

# FIG. 4

# FIG. 5A

# FIG. 5B

# FIG. 5C

# FIG. 6

LG(fG) : L1, L2, L3, L4, L5, CG

# FIG. 7

# FIG. 8

# FIG. 9

# FIG. 10

| Angle (°) | 0 | 0 | βx=3.6 | βy=3.6 |
|---|---|---|---|---|
| dx, dy (mm) | - | - | dx=2.5 | dy=2.5 |
| a0=0.9°,f0=500mm, 2W0=15.7mm ⇩ NA=0.2 (11.5°) | | | | |

FWHM  HML

MTM

# FIG. 11

# FIG. 12

# FIG. 13

# FIG. 14

# FIG. 15

Z

100 : SUB, DISL, ENC, SENL

# FIG. 16

# FIG. 17

# FIG. 18

# FIG. 19

# FIG. 20

# FIG. 21

# FIG. 22

# FIG. 23

# FIG. 24

# FIG. 25

EP 4 474 884 B1

# FIG. 26

62

# FIG. 27

# FIG. 28

SUB : SUB1, SUB2

# FIG. 29

# FIG. 30

```
                                                      S1
              ┌─────────────────┐
              │      START      │
              └────────┬────────┘
                       │
    ┌──────────────────▼──────────────────┐
    │  FORM A PLURALITY OF DISPLAY CELLS ON FIRST  │── S110
    │      SURFACE OF MOTHER SUBSTRATE             │
    └──────────────────┬──────────────────┘
                       │
    ┌──────────────────▼──────────────────┐
    │  ATTACH FIRST PROTECTIVE FILMS TO DISPLAY CELLS,  │── S120
    │  RESPECTIVELY, AND TEST EACH OF DISPLAY CELLS     │
    └──────────────────┬──────────────────┘
                       │
    ┌──────────────────▼──────────────────┐
    │  FORM A PLURALITY OF FIRST LASER IRRADIATION  │
    │  AREAS ALONG EDGES OF EACH DISPLAY CELL AND   │
    │  EDGES OF EACH BENDING AREA BY IRRADIATING FIRST │── S130
    │  LASER BEAM ONTO SECOND SURFACE FACING FIRST  │
    │  SURFACE OF MOTHER SUBSTRATAE                  │
    └──────────────────┬──────────────────┘
                       │
    ┌──────────────────▼──────────────────┐
    │  FORM A PLURALITY OF SECOND LASER IRRADIATION │
    │  AREAS FOR FORMING THROUGH HOLE IN EACH OF    │
    │  DISPLAY CELLS BY IRRADIATING SECOND LASER BEAM │── S140
    │  ONTO SECOND SURFACE OF MOTHER SUBSTRATE      │
    └──────────────────┬──────────────────┘
                       │
    ┌──────────────────▼──────────────────┐
    │  ATTACH SECOND PROTECTIVE FILM ONTO FIRST     │── S150
    │          PROTECTIVE FILMS                     │
    └──────────────────┬──────────────────┘
                       │
    ┌──────────────────▼──────────────────┐
    │  SPRAY ETCHANT ONTO SECOND SURFACE OF MOTHER  │
    │  SUBSTRATE WITHOUT USING MASK TO REDUCE       │
    │  THICKNESS OF MOTHER SUBSTRATE WHILE CUTTING  │── S160
    │  MOTHER SUBSTRATE ALONG FIRST LASER IRRADIATION │
    │  AREAS AND SECOND LASER IRRADIATION AREAS AND │
    │  DETACH SECOND PROTECTIVE FILM                │
    └──────────────────┬──────────────────┘
                       │
    ┌──────────────────▼──────────────────┐
    │  ATTACH DRIVING ICs AND CIRCUIT BOARDS TO EACH │
    │  OF DISPLAY CELLS AND DETACH FIRST PROTECTIVE  │── S170
    │  FILMS FROM DISPLAY CELLS, RESPECTIVELY        │
    └──────────────────┬──────────────────┘
                       │
              ┌────────▼────────┐
              │       END       │
              └─────────────────┘
```

# FIG. 31

(a)

CL1

CH1

TCH1

MSUB

LR1

(b)

CL2

CH2

TCH2

MSUB

LR2

# FIG. 32

# FIG. 33

# FIG. 34

# FIG. 35

# FIG. 36

# FIG. 37

# FIG. 38

# FIG. 39

# FIG. 40

# FIG. 41

# FIG. 42

DPC

DISL { SENL
ENC
EML
TFTL

US
SS1

SUB

BS    IP1_1

XG

Z
⊗ Y    → X

DPC

SENL
ENC
EML
TFTL } DISL

SUB

XG'

# FIG. 43

# FIG. 44

# FIG. 45

## FIG. 46

# FIG. 47

**REFERENCES CITED IN THE DESCRIPTION**

**Patent documents cited in the description**

- JP 7090930 B